# EUROPEAN PATENT APPLICATION

(11) **EP 4 451 825 A1**
(43) Date of publication of application: **23.10.2024**
(21) Application number: 23806882.9
(22) Date of filing: 15.05.2023
(51) Int. Cl.: H10K 50/813, H10K 59/121

(54) **DISPLAY SUBSTRATE AND DISPLAY APPARATUS**

(30) Priority: 16.05.2022 CN 202210530530
(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: GUAN, Xinxing, Beijing 100176 (CN); CHEN, Youchun, Beijing 100176 (CN); BAI, Shanshan, Beijing 100176 (CN); LI, Yansong, Beijing 100176 (CN)
(74) Representative: Brötz, Helmut
(86) International application number: PCT/CN2023/094242
(87) International publication number: WO 2023/221930

(57) **Abstract**

A display substrate and a display apparatus. The display substrate comprises: a base substrate; and a plurality of sub-pixels, which are located on the base substrate, wherein the shape of an orthographic projection of at least one sub-pixel on the base substrate comprises a first shape, which comprises a first bending edge and a second bending edge; two ends of the first bending edge are respectively connected to two ends of the second bending edge, so as to form a first connection point and a second connection point; the length of a first connection line between the first connection point and the second connection point is the maximum length of the first shape in the extension direction of the first connection line, and the first shape is divided by the first connection line into a first sub-part comprising the first bending edge and a second sub-part comprising the second bending edge; and the area of the first sub-part is greater than the area of the second sub-part, and the maximum vertical distance between each point on the first bending edge and the first connection line is greater than the maximum vertical distance between each point on the second bending edge and the first connection line. In this way, the display substrate can reduce or even avoid a color separation phenomenon.

## Description

This patent application claims priority to the Chinese Patent Application No. 202210530530.1 filed on May 16, 2022, for all purposes, the disclosure of which is incorporated herein by reference in its entirety as part of the embodiment of the present disclosure.

### TECHNICAL FIELD

Embodiments of the present disclosure relate to a display substrate and a display apparatus.

### BACKGROUND

Organic light emitting diode (OLED) display technology is gradually being used in various electronic products such as smartphones, navigators, digital cameras, and televisions due to its advantages such as thinness, self-illumination, wide viewing angle, fast response speed, high brightness, and low power consumption, and has become the main development direction in the display field.

Generally, an organic light emitting diode display apparatus includes a base substrate, a pixel driving circuit and an organic light emitting structure; the organic light emitting structure may include an anode, a light emitting functional layer and a cathode; the pixel driving circuit is located on the base substrate, and the anode is located at a side of the pixel driving circuit away from the base substrate, and is electrically connected with the corresponding pixel driving circuit; the light emitting functional layer is located at a side of the anode away from the pixel driving circuit, and the cathode is located at a side of the light emitting functional layer away from the anode. The pixel driving circuit can provide driving current to the organic light emitting diode to perform light emitting display.

### SUMMARY

Embodiments of the present disclosure provide a display substrate and a display apparatus. The display substrate includes a base substrate; and a plurality of sub-pixels located on the base substrate; a shape of an orthographic projection of at least one sub-pixel on the base substrate includes a first shape, the first shape includes a first curved edge and a second curved edge, two ends of the first curved edge and two ends of the second curved edge are respectively connected to form a first connection point and a second connection point; a length of a first connection line between the first connection point and the second connection point is a maximum length of a first shape in an extension direction of the first connection line, the first shape is divided by the first connection line into a first sub-section including a first curved edge and a second sub-section including a second curved edge; an area of the first sub-section is greater than an area of the second sub-section, a maximum vertical distance between each point on the first curved edge and the first connection line is greater than a maximum vertical distance between each point on the second curved edge and the first connection line. In this way, the display substrate can reduce or even avoid the occurrence of color separation, and can also flexibly adjust the size and distance of different sub-pixels according to the light emitting efficiency and color indicators of different color sub-pixels, to achieve a better display effect. In addition, the display substrate can also form spacers, fingerprint recognition units, photosensitive devices and other functional components at positions where the second curved edge is away from the first curved edge, thus other functions can be better integrated on the display substrate. It should be noted that the above-mentioned color indicators may be parameters such as brightness, color gamut, color temperature, and wavelength of light emitted by sub-pixels.

At least one embodiment of the present disclosure provides a display substrate, which includes: a base substrate; a plurality of sub-pixels, located on the base substrate; a shape of an orthographic projection of at least one of the plurality of sub-pixels on the base substrate comprises a first shape, the first shape comprises a first curved edge and a second curved edge, two ends of the first curved edge and two ends of the second curved edge are respectively connected to form a first connection point and a second connection point; a length of a first connection line between the first connection point and the second connection point is a maximum length of the first shape in an extension direction of the first connection line, the first shape is divided by the first connection line into a first sub-section comprising the first curved edge and a second sub-section comprising the second curved edge; an area of the first sub-section is greater than an area of the second sub-section, a maximum vertical distance between each point on the first curved edge and the first connection line is greater than a maximum vertical distance between each point on the second curved edge and the first connection line.

For example, in the display substrate provided by an embodiment of the present disclosure, a curvature of a vertex of the first curved edge away from the first connection line is greater than a curvature of a vertex of the second curved edge away from the first connection line.

For example, in the display substrate provided by an embodiment of the present disclosure, the first curved edge is a continuously curved edge, and the second curved edge is a continuously curved edge.

For example, in the display substrate provided by an embodiment of the present disclosure, the first curved edge is a continuously curved edge, the second curved edge comprises a first sub-curved edge, a second sub-curved edge and a first straight edge, and the first straight edge is connected with the first sub-curved edge and the second sub-curved edge respectively.

For example, in the display substrate provided by an embodiment of the present disclosure, the plurality of sub-pixels comprise first color sub-pixels, second color sub-pixels and third color sub-pixels, a shape of an orthographic projection of each of the third color sub-pixels on the base substrate is the first shape; a plurality of third color sub-pixels are arranged in an array along a row direction and a column direction to form a third color sub-pixel row extending along the row direction, the plurality of third color sub-pixel rows are arranged sequentially along the column direction; the first curved edge and the second curved edge of the first shape have an arrangement order in a direction perpendicular to the first connection line, in a same third color sub-pixel row, arrangement orders of two adjacent of the third color sub-pixels are opposite.

For example, in the display substrate provided by an embodiment of the present disclosure, an extension direction of the first connection line of the first shape of the third color sub-pixel in one of two adjacent third color sub-pixel rows is parallel to the row direction, and an extension direction of the first connection line of the first shape of the third color sub-pixel in the other of the two adjacent third color sub-pixel rows is parallel to the column direction.

For example, in the display substrate provided by an embodiment of the present disclosure, arrangement orders of the first curved edge and the second curved edge comprise a first order and a second order that are opposite to each other, in a same third color sub-pixel row, a difference between a number of the third color sub-pixels in the first order and a number of the third color sub-pixels in the second order is less than 10.

For example, in the display substrate provided by an embodiment of the present disclosure, a shape of an orthographic projection of at least one of the sub-pixels on the base substrate comprises a second shape, the second shape comprises a third curved edge and a fourth curved edge, two ends of the third curved edge and two ends of the fourth curved edge are respectively connected to form a third connection point and a fourth connection point; a length of the second connection line between the third connection point and the fourth connection point is a maximum length of the second shape in an extension direction of the second connection line, the second shape is divided by the second connection line into a third sub-section comprising the third curved edge and a fourth sub-section comprising the fourth curved edge; an area of the third sub-section is greater than an area of the fourth sub-section, and a maximum vertical distance between each point on the third curved edge and the second connection line is greater than a maximum vertical distance between each point on the fourth curved edge and the second connection line.

For example, in the display substrate provided by an embodiment of the present disclosure, a curvature of a vertex of the third curved edge away from the second connection line is greater than a curvature of a vertex of the fourth curved edge away from the second connection line.

For example, in the display substrate provided by an embodiment of the present disclosure, the third curved edge is a continuously curved edge, and the fourth curved edge is a continuously curved edge.

For example, in the display substrate provided by an embodiment of the present disclosure, the third curved edge is a continuously curved edge, the fourth curved edge comprises a third sub-curved edge, a fourth sub-curved edge and a second straight edge, and the second straight edge is connected with the third sub-curved edge and the fourth sub-curved edge respectively.

For example, in the display substrate provided by an embodiment of the present disclosure, a length of the second connection line is smaller than a length of the first connection line.

For example, in the display substrate provided by an embodiment of the present disclosure, the plurality of sub-pixels comprise first color sub-pixels, second color sub-pixels and third color sub-pixels, a shape of an orthographic projection of the first color sub-pixel on the base substrate is the second shape; a plurality of the first color sub-pixels are arranged in an array along the row direction and the column direction to form first color sub-pixel rows extending along the row direction, the plurality of first color sub-pixel rows are arranged sequentially along the column direction; the third curved edge and the fourth curved edge of the second shape have an arrangement order in a direction perpendicular to the second connection line, in a same first color sub-pixel row, arrangement orders of two adjacent first color sub-pixels are opposite.

For example, in the display substrate provided by an embodiment of the present disclosure, an extension direction of the second connection line of the second shape of the first color sub-pixel in one of two adjacent first color sub-pixel rows is parallel to the row direction, and an extension direction of the second connection line of the second shape of the first color sub-pixel in the other of the two adjacent first color sub-pixel rows is parallel to the column direction.

For example, in the display substrate provided by an embodiment of the present disclosure, arrangement orders of the third curved edge and the fourth curved edge comprise a third order and a fourth order that are opposite to each other, in a same first color sub-pixel row, a difference between a number of the first color sub-pixels with the third order and a number of the first color sub-pixels with the fourth order is less than 10.

For example, in the display substrate provided by an embodiment of the present disclosure, a shape of an orthographic projection of at least one of the sub-pixels on the base substrate comprises a third shape, the third shape comprises a fifth curved edge and a sixth curved edge, two ends of the fifth curved edge and two ends of the sixth curved edge are respectively connected to form a fifth connection point and a sixth connection point; a length of a third connection line between the fifth connection point and the sixth connection point is a maximum length of the third shape in an extension direction of the third connection line, the third shape is divided by the third connection line into a fifth sub-section comprising the fifth curved edge and a sixth sub-section comprising the sixth curved edge; an area of the fifth sub-section is equal to an area of the sixth sub-section, and the fifth curved edge and the sixth curved edge are arranged axially symmetrically with respect to the third connection line.

For example, in the display substrate provided by an embodiment of the present disclosure, the fifth curved edge is a continuously curved edge, and the sixth curved edge is a continuously curved edge.

For example, in the display substrate provided by an embodiment of the present disclosure, a length of the third connection line is shorter than a length of the first connection line.

For example, in the display substrate provided by an embodiment of the present disclosure, the plurality of sub-pixels comprise first color sub-pixels, second color sub-pixels and third color sub-pixels, and a shape of an orthographic projection of the second color sub-pixel on the base substrate is the third shape.

For example, in the display substrate provided by an embodiment of the present disclosure, the plurality of sub-pixels are arranged in an array on the base substrate to form a display array, the plurality of sub-pixels comprise boundary sub-pixels located at edges of the display array, a shape of an orthographic projection of at least one of the boundary sub-pixels on the base substrate comprises a fourth shape, the fourth shape comprises a seventh curved edge and an eighth curved edge, two ends of the seventh curved edge and two ends of the eighth curved edge are respectively connected to form a seventh connection point and an eighth connection point; a length of a fourth connection line between the seventh connection point and the eighth connection point is a maximum length of the fourth shape in an extension direction of the fourth connection line, the fourth shape is divided by the fourth connection line into a seventh sub-section comprising the seventh curved edge and an eighth sub-section comprising the eighth curved edge; an area of the seventh sub-section is equal to an area of the eighth sub-section, a shape of the seventh curved edge is the same as a shape of the second curved edge, and a shape of the eighth curved edge is the same as the shape of the second curved edge.

For example, in the display substrate provided by an embodiment of the present disclosure, the seventh curved edge is a continuously curved edge, and the eighth curved edge is a continuously curved edge.

For example, in the display substrate provided by an embodiment of the present disclosure, a length of the fourth connection line is equal to a length of the first connection line.

For example, the display substrate provided by an embodiment of the present disclosure further includes: a plurality of anodes, located on the base substrate; a pixel defining layer, located on the base substrate; and a light emitting functional layer, located at a side of the plurality of anodes and the pixel defining layer away from the base substrate, the pixel defining layer is arranged with a plurality of pixel openings, the light emitting functional layer comprises a light emitting layer, and the light emitting layer comprises a plurality of light emitting parts, the plurality of light emitting parts are arranged in the plurality of pixel openings and driven by the anodes exposed by the pixel openings, to form a plurality of light emitting structures of the plurality of sub-pixels, a shape of an orthographic projection of each of the sub-pixels on the base substrate is a shape of an orthographic projection of the pixel opening corresponding to the sub-pixel on the base substrate.

For example, in the display substrate provided by an embodiment of the present disclosure, in a sub-pixel having the first shape, a shape of an orthographic projection of the light emitting part on the base substrate is a rounded rectangle, the rounded rectangle comprises a first rounded corner part and a second rounded corner part that are oppositely arranged, and the first rounded corner part is located at a side of the first curved edge away from the second curved edge, the second rounded corner part is located at a side of the second curved edge away from the first curved edge, a distance between a first vertex of the first rounded corner part away from the pixel opening and the first curved edge is less than a distance between a second vertex of the second rounded corner part away from the pixel opening and the second curved edge.

For example, in the display substrate provided by an embodiment of the present disclosure, in the sub-pixel having the first shape, the rounded rectangle further comprises a third rounded corner part and a fourth rounded corner part arranged oppositely, a line connecting a third vertex of the third rounded corner part away from the pixel opening and a fourth vertex of the fourth rounded corner part far away from the pixel opening is substantially parallel to the first connection line.

For example, the display substrate provided by an embodiment of the present disclosure further includes: a color filter layer, comprising a plurality of color filters, shapes of the plurality of color filters define a plurality of light emitting regions of the plurality of sub-pixels, and a shape of an orthographic projection of each of the sub-pixels on the base substrate is a shape of an orthographic projection of one of the color filters corresponding to the sub-pixel on the base substrate.

For example, in the display substrate provided by an embodiment of the present disclosure, the plurality of sub-pixels comprise a plurality of sub-pixel groups, each of the sub-pixel groups comprises one first color sub-pixel, two second color sub-pixels and one third color sub-pixel; in each of the sub-pixel groups, the first color sub-pixel and the third color sub-pixel are arranged along a first direction, the two second color sub-pixels are arranged along the second direction, a line connecting centers of the first color sub-pixel and the third color sub-pixel intersects a line connecting centers of the two second color sub-pixels.

For example, in the display substrate provided by an embodiment of the present disclosure, in each of the sub-pixel groups, a first center connection line and a second center connection line between the center of the first color sub-pixel and the centers of the two second color sub-pixels and a third center connection line and a fourth center connection line between the center of the third color sub-pixel and the centers of the two second color sub-pixels form a virtual quadrilateral, and at least one interior angle of the virtual quadrilateral is not equal to 90 degrees.

For example, in the display substrate provided by an embodiment of the present disclosure, a value range of an interior angle of the virtual quadrilateral is from 84 degrees to 94 degrees.

For example, in the display substrate provided by an embodiment of the present disclosure, the center lines connecting the two first color sub-pixels and the two third color sub-pixels in the two adjacent sub-pixel groups in the second direction may form a second virtual quadrilateral, and at least one interior angle of the second virtual quadrilateral is not equal to 90 degrees.

For example, in the display substrate provided by an embodiment of the present disclosure, in each of the sub-pixel groups, the first color sub-pixel and the two second color sub-pixels have a first distance and a second distance respectively, the third color sub-pixel and the two second color sub-pixels have a third distance and a fourth distance respectively; at least two of the first distance, the second distance, the third distance and the fourth distance are equal in size.

For example, in the display substrate provided by an embodiment of the present disclosure, the first distance, the second distance, the third distance and the fourth distance are equal.

At least one embodiment of the present disclosure further provides a display apparatus, which includes any one of the abovementioned display substrate.

### BRIEF DESCRIPTION OF DRAWINGS

In order to clearly illustrate technical solutions of the embodiments of the present disclosure, the drawings of the embodiments will be briefly described. It is obvious that the described drawings in the following are only related to some embodiments of the present disclosure and thus are not construed as any limitation to the present disclosure.
Fig. 1A is a planar schematic diagram of a display substrate provided by an embodiment of the present disclosure.
Fig. 1B is a schematic diagram of a first shape in another display substrate provided by an embodiment of the present disclosure.
Fig. 1C is a schematic diagram of a first shape in another display substrate provided by an embodiment of the present disclosure.
Fig. 1D is a schematic diagram of a first shape in another display substrate provided by an embodiment of the present disclosure.
Fig. 2 is a cross-sectional schematic diagram of a display substrate provided by an embodiment of the present disclosure.
Fig. 3 is a planar schematic diagram of another display substrate provided by an embodiment of the present disclosure.
Fig. 4 is a planar schematic diagram of another display substrate provided by an embodiment of the present disclosure.
Fig. 5A is a planar schematic diagram of another display substrate provided by an embodiment of the present disclosure.
Fig. 5B is a cross-sectional schematic diagram of another display substrate provided by an embodiment of the present disclosure.
Fig. 5C is a cross-sectional schematic diagram of another display substrate provided by an embodiment of the present disclosure.
FIGS. 6A to 6B are planar schematic diagrams of another display substrate provided by an embodiment of the present disclosure.
Fig. 6C is a planar schematic diagram of another display substrate provided by an embodiment of the present disclosure.
Fig. 6D is a planar schematic diagram of another display substrate provided by an embodiment of the present disclosure.
Fig. 7 is a planar schematic diagram of another display substrate provided by an embodiment of the present disclosure.
Fig. 8 is a planar schematic diagram of another display substrate provided by an embodiment of the present disclosure.
Fig. 9 is a planar schematic diagram of another display substrate provided by an embodiment of the present disclosure.
Fig. 10 is a planar schematic diagram of another display substrate provided by an embodiment of the present disclosure.
Fig. 11 is a planar schematic diagram of another display substrate provided by an embodiment of the present disclosure.
Fig. 12 is a planar schematic diagram of another display substrate provided by an embodiment of the present disclosure.
Fig. 13 is a planar schematic diagram of another display substrate provided by an embodiment of the present disclosure.
Fig. 14 is a planar schematic diagram of another display substrate provided by an embodiment of the present disclosure.
Fig. 15 is a planar schematic diagram of another display substrate provided by an embodiment of the present disclosure.
Fig. 16 is a planar schematic diagram of another display substrate provided by an embodiment of the present disclosure.
Fig. 17 is a planar schematic diagram of another display substrate provided by an embodiment of the present disclosure.
Fig. 18 is a planar schematic diagram of another display substrate provided by an embodiment of the present disclosure.
Fig. 19 is a planar schematic diagram of another display substrate provided by an embodiment of the present disclosure.
Fig. 20 is a planar schematic diagram of another display substrate provided by an embodiment of the present disclosure.
Fig. 21 is a schematic diagram of a display apparatus provided by an embodiment of the present disclosure.

### DETAILED DESCRIPTION

In order to make objectives, technical details, and advantages of the embodiments of the present disclosure clearer, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first", "second", etc., which are used in the present disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly.

Unless otherwise defined, the features such as "parallel", "vertical" and "identical" used in the embodiments of the present disclosure all include cases such as "parallel", "vertical" and "identical" in a strict sense, and cases such as "approximately parallel", "approximately vertical" and "approximately identical" contain certain errors. For example, the above-mentioned "approximately" can refer to that the difference of the compared objects is within 10% or 5% of the average value of the compared objects. When the number of one component or element is not specified in the following of the disclosed embodiment, it refers to that the component or element can be one or more, or can be understood as at least one. "At least one" refers to one or more, and "a plurality of' refers to at least two. The "arranged in the same layer" in the embodiment of the present disclosure refers to the relationship between a plurality of film layers formed by the same material after the same step (for example, one-step patterning process). The "same layer" here does not always refer to that the thickness of the plurality of film layers is the same or the height of the plurality of film layers in cross-sectional view is the same.

In an organic light emitting diode display apparatus, the light emitting functional layer may not only include a light emitting layer directly used for emitting light, but may also include functional film layers that assist light emitting, such as a hole injection layer, a hole transport layer, an electron transport layer, and an electron injection layer. During the research, the inventor(s) of the present application has noticed that current sub-pixels of some shapes (such as rectangle shapes) can easily cause color separation in certain products or environments.

In this regard, embodiments of the present disclosure provide a display substrate and a display apparatus. The display substrate includes a base substrate; a plurality of sub-pixels located on the base substrate; a shape of an orthographic projection of at least one sub-pixel on the base substrate includes a first shape, the first shape includes a first curved edge and a second curved edge, two ends of the first curved edge and two ends of the second curved edge are respectively connected to form a first connection point and a second connection point; a length of the first connection line between the first connection point and the second connection point is a maximum length of the first shape in an extension direction of the first connection line, the first shape is divided by the first connection line into a first sub-section including a first curved edge and a second sub-section including a second curved edge; an area of the first sub-section is greater than an area of the second sub-section, a maximum vertical distance between each point on the first curved edge and the first connection line is greater than a maximum vertical distance between each point on the second curved edge and the first connection line. In this way, the display substrate can reduce or even avoid color separation by configuring a shape including curved edges, and can also flexibly adjust the size and distance of different sub-pixels according to the luminous efficiency and color indicators of different color sub-pixels, to achieve a better display effect.

Hereinafter, the display substrate and the display apparatus provided by the embodiments of the present disclosure will be described in detail with reference to the accompanying drawings.

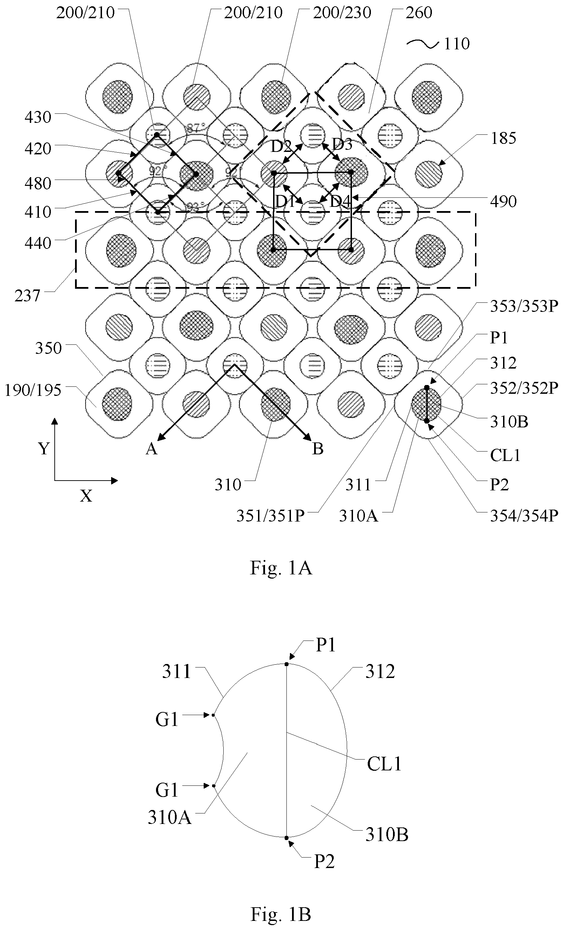

An embodiment of the present disclosure provides a display substrate. Fig. 1A is a planar schematic diagram of a display substrate provided by an embodiment of the present disclosure. As illustrated by Fig. 1A, the display substrate 100 includes a base substrate 110 and a plurality of sub-pixels 200; the plurality of sub-pixels 200 are located on the base substrate 110; a shape of an orthographic projection of at least one sub-pixel 200 on the base substrate 110 includes a first shape 310, the first shape 310 includes a first curved edge 311 and a second curved edge 312; two ends of the first curved edge 311 and the second curved edge 312 are respectively connected to form a first connection point P1 and a second connection point P2. That is, one end of the first curved edge 311 is connected to one end of the second curved edge 312 to form the first connection point P1, the other end of the first curved edge 311 is connected to the other end of the second curved edge 312 to form a second connection point P2. In this way, the first curved edge 311 and the second curved edge 312 may enclose an outer contour of the first shape 310.

As illustrated by Fig. 1A, a length of the first connection line CL1 between the first connection point P1 and the second connection point P2 is a maximum length of the first shape 310 in an extending direction of the first connection line CL1, the first shape 310 is divided by the first connection line CL1 into a first sub-section 310A including a first curved edge 311 and a second sub-section 310B including a second curved edge 312; an area of the first sub-section 310A is greater than an area of the second sub-section 310B, a maximum vertical distance between each point on the first curved edge 311 and the first connection line CL1 is greater than a maximum vertical distance between each point on the second curved edge 312 and the first connection line CL1. It should be noted that the maximum vertical distance between each point on the above-mentioned first curved edge and the first connection line refers to the largest one of a plurality of vertical distances between each point on the first curved edge and the first connection line, and the maximum vertical distance between each point on the second curved edge and the first connecting line refers to the largest one of a plurality of vertical distances between each point on the second curved edge and the first connection line.

In the display substrate provided by the embodiment of the present disclosure, because a shape of an orthographic projection of at least one sub-pixel on the base substrate includes a first shape, and the first shape includes a first curved edge and a second curved edge, therefore, the shape of the orthographic projection of at least one sub-pixel on the base substrate is smoother, thus the occurrence of color separation can be reduced or even avoided. In addition, because the first shape is divided by the first connection line into a first sub-section including the first curved edge and a second sub-section including the second curved edge; an area of the first sub-section is greater than an area of the second sub-section, a maximum vertical distance between each point on the first curved edge and the first connection line is greater than a maximum vertical distance between each point on the second curved edge and the first connection line, therefore, the sub-pixel having the first shape can better avoid the color separation phenomenon. In addition, the display substrate can flexibly adjust the size and distance of different sub-pixels according to the light emitting efficiency and color index of different color sub-pixels by setting the above-mentioned first curved edge and second curved edge, to achieve a better display effect. It should be noted that the above-mentioned color indicators may be parameters such as brightness, color gamut, color temperature, and wavelength of light emitted by sub-pixels.

On the other hand, because the maximum vertical distance between each point on the first curved edge and the first connection line is greater than the maximum vertical distance between each point on the second curved edge and the first connection line, therefore, the second curved edge has a larger space away from the first curved edge. In this way, the display substrate can also form spacers, fingerprint recognition units, face recognition units, photosensitive devices and other functional components at positions where the second curved edge is away from the first curved edge, thus other functions can be better integrated on the display substrate. In addition, the display substrate may also form a translucent or transparent region at a position where the second curved edge is away from the first curved edge, to allow light to penetrate the translucent or transparent region, thus a transparent display region is achieved. It should be noted that a photosensitive device, such as a camera, can be disposed on the back of the translucent or transparent region of the display substrate.

In some examples, as illustrated by Fig. 1A, a curvature of a vertex of the first curved edge 311 away from the first connection line CL1 is greater than a curvature of a vertex of the second curved edge 312 away from the first connection line CL1.

In some examples, as illustrated by Fig. 1A, the first curved edge 311 is a continuously curved edge, and the second curved edge 312 is a continuously curved edge. Of course, embodiments of the present disclosure include but are not limited thereto, the first curved edge can also be a discontinuous curved edge, for example, can include a short straight section, and the second curved edge may also be a discontinuous curved edge, for example, may include a short straight section.

In some examples, as illustrated by Fig. 1A, the plurality of sub-pixels 200 include first color sub-pixels 210, second color sub-pixels 220, and third color sub-pixels 230; the first color sub-pixels 210 are configured to emit light of a first color, the second color sub-pixels 220 are configured to emit light of a second color, and the third color sub-pixels 230 are configured to emit light of a third color; a shape of an orthographic projection of a third color sub-pixel 230 on the base substrate 110 is a first shape 310; a plurality of third color sub-pixels 230 are arranged in an array along the row direction and the column direction to form third color sub-pixel rows 237 extending along the row direction, a plurality of third color sub-pixel rows 237 are arranged sequentially along the column direction; the first curved edge 311 and the second curved edge 312 of the first shape 310 have an arrangement order in a direction perpendicular to the first connection line CL1, in a same third color sub-pixel row 237, two adjacent third color sub-pixels 230 are arranged in opposite order.

In the display substrate provided in the present example, because two adjacent third color sub-pixels in a same third color sub-pixel row are arranged in opposite order, therefore, in the same third color sub-pixel row, the distribution of the third color sub-pixels with different arrangement orders is relatively uniform, thus it can be ensured that the display effect presented by the display substrate under different viewing angles is the same, so as to improve the display uniformity under different viewing angles.

It should be noted that the shape of the orthographic projection of the third color sub-pixel on the base substrate in the display substrate shown in Fig. 1A is the first shape. however, embodiments of the present disclosure include but are not limited thereto, in some examples, one of the first color sub-pixel, the second color sub-pixel, and the third color sub-pixel has a first shape, the remaining two are round or oval. In some examples, two of the first color sub-pixel, the second color sub-pixel, and the third color sub-pixel have a first shape, the other one is round or oval. In some examples, three of the first color sub-pixel, the second color sub-pixel, and the third color sub-pixel all have the first shape.

In some examples, as illustrated by Fig. 1A, in a same third color sub-pixel row 237, a line connecting centers of the third color sub-pixels 230 is a polyline; that is, the centers of the third color sub-pixels 230 in the third color sub-pixel row 237 are not on a same straight line. A plurality of first color sub-pixels 210 are arranged in an array along the row direction and the column direction to form first color sub-pixel rows 217 extending along the row direction, a plurality of first color sub-pixel rows 217 are arranged sequentially along the column direction. In a same first color sub-pixel row 217, a line connecting centers of the first color sub-pixels 210 is a straight line; that is, the centers of the first color sub-pixels 210 in the first color sub-pixel row 217 are on the same straight line. Moreover, the above-mentioned straight lines and polylines can intersect. Of course, embodiments of the present disclosure include but are not limited thereto, the centers of the third color sub-pixels in the third color sub-pixel row may also be on the same straight line.

In some examples, as illustrated by Fig. 1A, an area of a third color sub-pixel 230 is larger than an area of a first color sub-pixel 210, and the area of the third color sub-pixel 230 is larger than an area of a second color sub-pixel 210. By setting an area of the sub-pixel with a lower light emitting lifetime to be larger, the service life of the sub-pixel with a lower light emitting lifetime can be increased, thus the service life of different sub-pixels can be balanced.

In some examples, the area of the third color sub-pixel 230 may also be smaller than the area of the first color sub-pixel 210, the area of the third color sub-pixel 230 may also be smaller than the area of the second color sub-pixel 210. In some display apparatuses, because the light loss of some sub-pixels is less than the light loss of other sub-pixels during the light emitting process, the areas of the some sub-pixels can be appropriately reduced to maximize the areas of other sub-pixels with greater light loss. For example, in a display apparatus with light conversion, an area of a sub-pixel with lower light conversion efficiency is smaller than an area of a sub-pixel with higher light conversion efficiency. For example, in a display apparatus with light conversion, the areas of sub-pixels that do not require light conversion are smaller than the areas of sub-pixels that require light conversion.

In some embodiments, the shape and area of each color sub-pixel may refer to the shape and the area of a part used to emit light. For example, the shape and the area of each sub-pixel may be the shape and the area defined by the pixel opening of the pixel defining layer, the pixel defining layer is arranged on a side of an electrode of the light emitting diode away from the base substrate, and exposes at least part of the electrode, a light emitting functional layer is formed in an opening of the pixel defining layer, another electrode of the light emitting diode is also arranged on the side of the light emitting functional layer away from the base substrate.

In some embodiments, the shape and the area of each color sub-pixel may refer to the shape and the area of a part used to emerge light. For example, the shape and the area of each sub-pixel is the shape and the area of the filter layer that transmits each color in the color filter layer, for example, the shape and the area of an opening of each color filter layer may be defined by a black matrix. For example, the first color may be red, the second color may be green, and the third color may be blue. Of course, the embodiments of the present disclosure include but are not limited thereto, and the first color, the second color and the third color may also be other colors.

In some examples, as illustrated by Fig. 1A, arrangement orders of the first curved edge 311 and the second curved edge 312 include a first order and a second order that are opposite to each other, in a same third color sub-pixel row 237, a difference between a number of the third color sub-pixels 230 in the first order and a number of the third color sub-pixels 230 in the second order is less than 10. Therefore, in the same third color sub-pixel row, distribution of the third color sub-pixels with different arrangement orders is relatively uniform, therefore, it can be ensured that the display effect presented by the display substrate under different viewing angles is the same, to improve the display uniformity under different viewing angles.

For example, in the same third color sub-pixel row 237, the difference between the number of the third color sub-pixels 230 having the first order and the number of the third color sub-pixels 230 having the second order is less than 2, therefore, the distribution of the third color sub-pixels with different arrangement orders is made more uniform.

For example, as illustrated by Fig. 1A, in the same third color sub-pixel row 237, the first curved edge 311 and the second curved edge 312 in the first shape 310 of one of the two adjacent third color sub-pixels 230 may be sequentially arranged in the direction from left to right in Fig. 1A, the first curved edge 311 and the second curved edge 312 in the first shape 310 of the other third color sub-pixel 230 of the two adjacent third color sub-pixels 230 may be sequentially arranged from right to left in Fig. 1A. For another example, as illustrated by Fig. 1A, in the same third color sub-pixel row 237, the first curved edge 311 and the second curved edge 312 in the first shape 310 of one of the two adjacent third color sub-pixels 230 may be sequentially arranged from top to bottom in Fig. 1A, the first curved edge 311 and the second curved edge 312 in the first shape 310 of the other third color sub-pixel 230 of the two adjacent third color sub-pixels 230 may be arranged sequentially from bottom to top in Fig. 1A.

In some examples, as illustrated by Fig. 1A, an extension direction of the first connection line CL1 of the first shape 310 of the third color sub-pixel 230 in one of the two adjacent third-color sub-pixel rows 237 is parallel to the row direction, and an extension direction of the first connection line CL1 of the first shape 310 of the third color sub-pixel 230 in the other third color sub-pixel row 237 of the two adjacent third color sub-pixel rows 237 is parallel to the column direction. In this way, the display substrate sets the extension direction of the first connection line of the third color sub-pixel in two adjacent third-color sub-pixel rows to be parallel to the row direction and the column direction respectively, which can further ensure that the display effect presented by the display substrate is the same under different viewing angles, furthermore, the display uniformity under different viewing angles is improved.

In some examples, as illustrated by Fig. 1A, a shape of the first color sub-pixel 210 may be circular, a shape of the second color sub-pixel 220 may be circular. Of course, embodiments of the present disclosure include but are not limited thereto, and the shape of the first color sub-pixel and the shape of the second color sub-pixel may also be an ellipse or a rounded rectangle.

In some examples, as illustrated by Fig. 1A, an area of the first color sub-pixel 210 is larger than an area of the second color sub-pixel 220. By setting the area of the sub-pixel with a lower light emitting lifetime among the first color sub-pixel and the second color sub-pixel to be larger, the service life of the sub-pixel with a lower light emitting lifetime can be increased, thereby balancing the service life of different sub-pixels.

In some examples, as illustrated by Fig. 1A, in at least part of the display region of the display substrate, all of the third color sub-pixels 230 have the same shape, all of the second color sub-pixels 220 has the same shape, and all of the first color sub-pixels 210 have the same shape. It should be noted that at least part of the above-mentioned display regions may be regions with similar pixel driving methods or similar display requirements, such as a region for light emitting display on the display substrate, a transparent display region, or a region where a camera, fingerprint recognition unit, face recognition unit, color filter unit or other functional components are arranged. Of course, embodiments of the present disclosure include but are not limited thereto, and the above-mentioned at least part of the display region may also include other regions in addition to the above-mentioned regions.

In some examples, at least part of the above-mentioned display region may be a region located close to a center of the display substrate. For another example, at least part of the above-mentioned display region may also be a region located close to an edge of the display region, such as an edge row or an edge column.

In some examples, at least part of the above-mentioned display region may include 10 rows and 10 columns of sub-pixels; that is, at least in the display region including 10 rows and 10 columns of sub-pixels, all of the third color sub-pixels have the same shape, all of the second color sub-pixels have the same shape, and all of the first color sub-pixels have the same shape.

In some examples, in more than 50% of the display region of the display substrate, all of the third color sub-pixels have the same shape, all of the second color sub-pixels have the same shape, and all of the first color sub-pixels have the same shape.

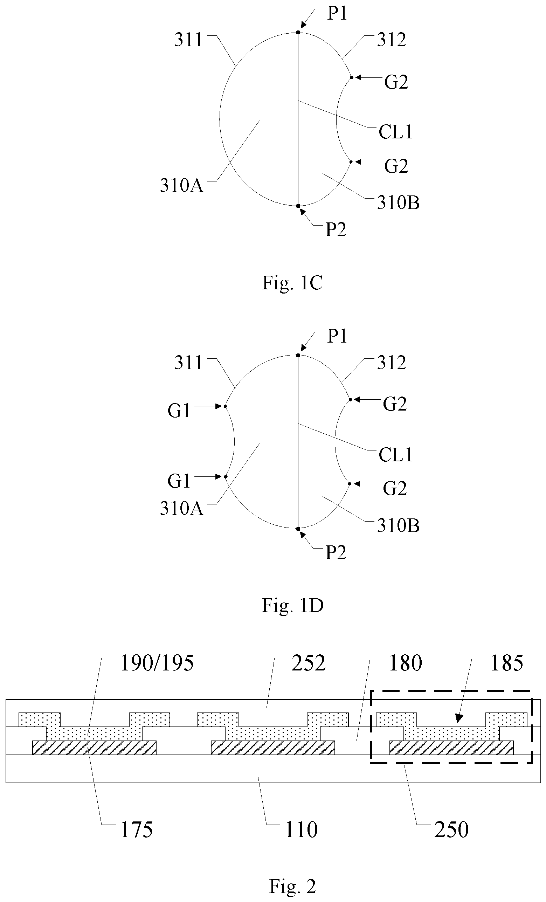

Fig. 2 is a cross-sectional schematic diagram of a display substrate provided by an embodiment of the present disclosure. As illustrated by Fig. 1A and Fig. 2, the display substrate 100 further includes a plurality of anodes 175, a pixel defining layer 180 and a light emitting functional layer 190; the plurality of anodes 175 are located on the base substrate 110; the pixel defining layer 180 is located on the base substrate 110; the light emitting functional layer 190 is located at a side of the plurality of anodes 175 and the pixel defining layer 180 away from the base substrate 110, a plurality of pixel openings 185 are arranged in the pixel defining layer 180, the light emitting functional layer 190 includes a light emitting layer 192, and the light emitting layer 192 includes a plurality of light emitting parts 195, the plurality of light emitting parts 195 are arranged in the plurality of pixel openings 185 and driven by the plurality of anodes 175 exposed by the plurality of pixel openings 185, to form a plurality of light emitting structures 250 of a plurality of sub-pixels 200; a shape of an orthographic projection of each sub-pixel 200 on the base substrate 110 is a shape of an orthographic projection of the pixel opening 185 corresponding to the sub-pixel 200 on the base substrate 110. That is, the display substrate may be an array substrate used for display. It should be noted that the above-mentioned light emitting part is arranged in the pixel opening means that the light emitting part is at least partially arranged in the pixel opening. A size of the light emitting part may be larger than a size of the pixel opening; in addition, the above-mentioned light emitting functional layer may not only include a light emitting functional layer directly used for emitting light, but may also include functional film layers that assist light emitting, such as a hole injection layer, a hole transport layer, an electron transport layer, and an electron injection layer.

In some examples, the display substrate can also define the shape of each sub-pixel by arranging a black matrix and a black matrix opening. In this case, a shape of the above-mentioned light emitting part and a shape of the corresponding pixel opening or black matrix opening may be the same or different; a center of the shape of the light emitting part and a center of the shape of the corresponding pixel opening or black matrix opening may be overlapped or may be not overlapped.

In some examples, in a certain sub-pixel, a shape of an orthographic projection of the pixel opening on the base substrate has a first shape, and a shape of an orthographic projection of the corresponding black matrix opening on the base substrate may be circular. For another example, the shape of the orthographic projection of the pixel opening on the base substrate is circular, and the shape of the orthographic projection of the corresponding black matrix opening on the base substrate may be a first shape. For another example, the shape of the orthographic projection of the pixel opening on the base substrate and the center of the orthographic projection of the black matrix opening on the base substrate may or may not coincide with each other.

In some examples, as illustrated by Fig. 1A, in the sub-pixel 230 having the first shape 310, a shape of an orthographic projection of the light emitting part 195 on the base substrate 110 is a rounded rectangle 350, the rounded rectangle 350 includes a first rounded corner part 351 and a second rounded corner part 352 arranged oppositely, the first rounded part 350 is located at a side of the first curved edge 311 away from the second curved edge 312, and the second rounded part 352 is located at a side of the second curved edge 312 away from the first curved edge 311; a distance between the first rounded corner part 351 and the first curved edge 311 of the first vertex 351P of the pixel opening 185 is smaller than a distance between the second vertex 352P of the second rounded corner part 352 away from the pixel opening 185 and the second curved edge 312. Because the distance between the first vertex of the first rounded part away from the pixel opening and the first curved edge is smaller than the distance between the second vertex of the second rounded part far away from the pixel opening and the second curved edge, the display apparatus can form spacers, fingerprint recognition units, photosensitive devices and other functional components at positions where the second curved edge is away from the first curved edge, thus other functions can be better integrated on the display substrate.

In some examples, in addition to the light emitting layer 192, the light emitting functional layer 190 may also include other film layers that assist light emitting, such as a hole injection layer, a hole transport layer, an electron injection layer, an electron transport layer; at least one of these film layers can also be patterned to have the same or similar pattern as the light emitting layer; and at least one of these film layers may also be not patterned.

In some examples, as illustrated by Fig. 1A, in the sub-pixel 230 having the first shape 310, the rounded rectangle 350 also includes a third rounded corner part 353 and a fourth rounded corner part 354 arranged oppositely, a line connecting the third vertex 353P of the third rounded corner part 353 away from the pixel opening 185 and the fourth vertex 354P of the fourth rounded corner part 354 away from the pixel opening 185 is substantially parallel to the first connection line CL1.

In some examples, as illustrated by Fig. 1A, a plurality of sub-pixels 200 can be arranged on the base substrate 110 according to a certain pixel arrangement structure array, to perform light emitting display.

In some examples, as illustrated by Fig. 1A, the plurality of sub-pixels 200 include a plurality of sub-pixel groups 260, each of the plurality of sub-pixel groups 260 includes one first color sub-pixel 210, two second color sub-pixels 220 and one third color sub-pixel 230; in each of the plurality of sub-pixel groups 260, the first color sub-pixel 210 and the third color sub-pixel 230 are arranged along the first direction X, the two second color sub-pixels 220 are arranged along the second direction Y, a line connecting a center of the first color sub-pixel 210 and a center of the third color sub-pixel 230 is intersected with a line connecting centers of the two second color sub-pixels 220. In a case that the display substrate arranged in the present example is used for display, the two second color sub-pixels 220 in a pixel group may form two independent light emitting pixel points with the first color sub-pixel 210 and the third color sub-pixel 230, respectively, thus higher resolution is achieved through the principle of pixel borrowing. It should be noted that the above-mentioned "the line connecting centers" refers to a line connecting centers of orthographic projections of two sub-pixels on the base substrate; the above-mentioned "center" may be a brightness center of the sub-pixel or a geometric center of the orthographic projection of the sub-pixel on the base substrate. In addition, a shape of the above-mentioned sub-pixel can be a range of an actual effective light emitting region of the sub-pixel, or can be a range of the light emitting region restricted by some limiting structures or blocking structures.

In some examples, as illustrated by Fig. 1A, the first connection line CL1 may extend along the first direction X or the second direction Y. Of course, embodiments of the present disclosure include but are not limited thereto, and an extension direction of the first connection line forms a certain angle with the first direction X or the second direction Y, for example, the angle between the extension direction of the first connection line and the first direction X or the second direction Y is in a range of 40 degrees to 50 degrees.

In some examples, as illustrated by Fig. 1A, the first shape 310 may be an axially symmetrical shape. In this case, a symmetry axis of the first shape 310 may be the above-mentioned first direction X or second direction Y.

In some examples, as illustrated by Fig. 1A, a shape of an orthographic projection of the first color sub-pixel 210 on the base substrate 110 may also be an axially symmetrical shape, and a shape of an orthographic projection of the second color sub-pixel 220 on the base substrate 110 may be an axially symmetrical shape.

In some examples, as illustrated by Fig. 1A, in each sub-pixel group 260, a first center connection line 410 and a second center connection line 420 between the center of the first color sub-pixel 210 and the centers of the two second color sub-pixels 220 and a third center connection line 430 and a fourth center connection line 440 between the center of the third color sub-pixel 230 and the centers of the two second color sub-pixels 220 form a first virtual quadrilateral 480, at least one interior angle of the first virtual quadrilateral 480 is not equal to 90 degrees. In this way, the display substrate can better avoid the occurrence of color separation, and can also flexibly adjust the size and distance of different sub-pixels according to the light emitting efficiency and color indicators of different color sub-pixels, to achieve a better display effect.

In some examples, as illustrated by Fig. 1A, a value range of an interior angle of the above-mentioned first virtual quadrilateral 480 is from 84 degrees to 94 degrees. For example, the interior angle of the above-mentioned virtual quadrilateral can be 87 degrees, 92 degrees, and 93 degrees.

In some examples, the above-mentioned first virtual quadrilateral may be a parallelogram, a rhombus or a trapezoid. Of course, embodiments of the present disclosure include but are not limited thereto, and the interior angle of the above-mentioned first virtual quadrilateral may also be equal to 90 degrees, that is, the above-mentioned first virtual quadrilateral is a rectangle.

In some examples, as illustrated by Fig. 1A, lines connecting the centers of the two first color subpixels 210 and the centers of the two third color subpixels 230 in the two adjacent subpixel groups 260 in the second direction may form a second virtual quadrilateral 490, and at least one interior angle of the second virtual quadrilateral 490 is not equal to 90 degrees. In this way, the display substrate can better avoid the occurrence of color separation, and can also flexibly adjust the size and distance of different sub-pixels according to the light emitting efficiency and color indicators of different color sub-pixels, to achieve a better display effect.

In some examples, the above-mentioned second virtual quadrilateral may be a parallelogram, a rhombus or a trapezoid. Of course, embodiments of the present disclosure include but are not limited thereto. The interior angle of the above-mentioned second virtual quadrilateral may also be equal to 90 degrees, that is, the above-mentioned second virtual quadrilateral is a rectangle.

In some examples, as illustrated by Fig. 1A, in each of the sub-pixel groups 260, the first color sub-pixel 210 and the two second color sub-pixels 220 have a first distance D1 and a second distance D2 respectively, the third color sub-pixel 230 and the two second color sub-pixels 220 have a third distance D3 and a fourth distance D4 respectively; at least two of the first distance D1, the second distance D2, the third distance D3 and the fourth distance D4 are equal in size. In this way, the display substrate can ensure that each sub-pixel is evenly distributed, thereby increasing the pixel density while making full use of process accuracy. For example, the distance between two sub-pixels is the closest distance between boundaries of the two sub-pixels. For example, a distance between two sub-pixels is a distance between a line passing through centers of the two sub-pixels and intersection points of the boundaries of the two sub-pixels.

In some examples, as illustrated by Fig. 1A, the first distance D1, the second distance D2, the third distance D3 and the fourth distance D4 are all equal, to further ensure that each sub-pixel is evenly distributed, thus the pixel density can be further improved while making full use of process accuracy. Of course, embodiments of the present disclosure include but are not limited thereto. For example, the first distance D1 and the second distance D2 are equal, and the third distance D3 and the fourth distance D4 are different; for another example, the first distance D1, the second distance D2 and the third distance are equal, and the third distance D3 and the fourth distance D4 are different.

In some examples, a ratio of any two values of the first distance D1, the second distance D2, the third distance D3, and the fourth distance D4 may range from 0.7 to 1.5.

In some examples, a ratio of the aperture ratio of the second color sub-pixel 220 to the aperture ratio of the first color sub-pixel 210 ranges from 1 to 1/3; a ratio of the aperture ratio of the second color sub-pixel 220 to the aperture ratio of the third color sub-pixel 230 ranges from 1 to 1/3; and a ratio of the aperture ratio of the first color sub-pixel 210 to the aperture ratio of the third color sub-pixel 230 ranges from 1 to 1/3. Of course, embodiments of the present disclosure include but are not limited thereto.

Fig. 1B is a schematic diagram of a first shape in another display substrate provided by an embodiment of the present disclosure; Fig. 1C is a schematic diagram of a first shape in another display substrate provided by an embodiment of the present disclosure; and Fig. 1D is a schematic diagram of a first shape in another display substrate provided by an embodiment of the present disclosure.

In some examples, as illustrated by Fig. 1B, the first curved edge 311 may include a first inflection point G1, bending directions of the first curved edge 311 on both sides of the first inflection point G1 are opposite; for example, the first curved edge 311 may include two first inflection points G1, thus two outwardly protruding curved line segments and one inwardly concave curved line segment are formed.

In some examples, as illustrated by Fig. 1C, the second curved edge 312 may include a second inflection point G2, bending directions of the second curved edge 312 on both sides of the second inflection point G1 are opposite; for example, the second curved edge 312 may include two second inflection points G2, thus two outwardly protruding curved line segments and one inwardly concave curved line segment are formed.

In some examples, as illustrated by Fig. 1D, the first curved edge 311 may include a first inflection point G1, bending directions of the first curved edge 311 on both sides of the first inflection point G1 are opposite; for example, the first curved edge 311 may include two first inflection points G1, thus two outwardly protruding curved line segments and one inwardly concave curved line segment are formed. At the same time, the second curved edge 312 may include a second inflection point G2, bending directions of the second curved edge 312 on both sides of the second inflection point G1 are opposite; for example, the second curved edge 312 may include two second inflection points G2, thus two outwardly protruding curved line segments and one inwardly concave curved line segment are formed.

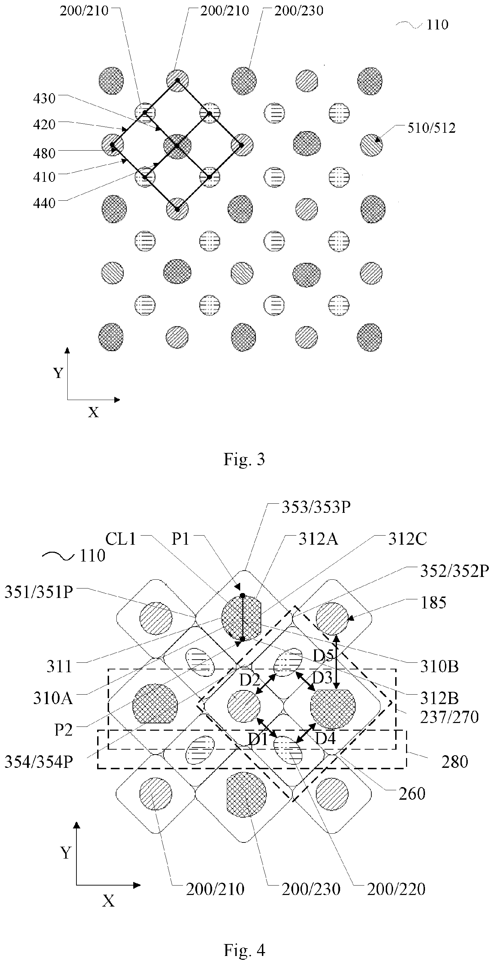

Fig. 3 is a planar schematic diagram of another display substrate provided by an embodiment of the present disclosure. As illustrated by Fig. 3, the display substrate 100 further includes a color filter layer 510, the color filter layer 510 includes a plurality of color filters 512; shapes of the plurality of color filters 512 define a plurality of light emitting regions of the plurality of sub-pixels 200, a shape of an orthographic projection of each sub-pixel 200 on the base substrate 110 is a shape of an orthographic projection of the color filter 512 corresponding to the sub-pixel 200 on the base substrate 110.

In some examples, the display substrate is a color filter substrate.

In some examples, the display substrate is a display substrate including both a light emitting element and a color filter, the shape of the orthographic projection of each sub-pixel on the base substrate is a shape of an overlapping part of an opening of a corresponding pixel definition layer of the light emitting element and the corresponding color filter in a direction perpendicular to the base substrate. For example, the shape of the overlapping part of the opening of the pixel defining layer corresponding to the light emitting element and the corresponding color filter in the direction perpendicular to the base substrate is a shape of the color defining layer opening, the projection of the opening of the pixel definition layer on the base substrate falls within the projection of the corresponding color filter on the base substrate. For example, the shape of the overlapping part of the opening of the pixel defining layer corresponding to the light emitting element and the corresponding color filter in the direction perpendicular to the base substrate is the shape of the color filter, and the projection of the color filter on the base substrate falls into the projection of the opening of the corresponding pixel definition layer on the base substrate.

In some examples, as illustrated by Fig. 3, a shape of an orthographic projection of the color filter 512 corresponding to the first color sub-pixel 210 on the base substrate 110 is circular; a shape of an orthographic projection of the color filter 512 corresponding to the second color sub-pixel 220 on the base substrate 110 is circular; and a shape of an orthographic projection of the color filter 512 corresponding to the third color sub-pixel 230 on the base substrate 110 is the first shape 310.

In some examples, as illustrated by Fig. 3, a first curved edge and a second curved edge of the color filter 512 corresponding to the third color sub-pixel 230 have an arrangement order in a direction perpendicular to a first connection line CL 1, in a same third color sub-pixel row, two adjacent third color sub-pixels are arranged in the opposite order, therefore, it can be ensured that the display effect presented by the display substrate under different viewing angles is the same, to improve the display uniformity under different viewing angles. It should be noted that the arrangement order of the above-mentioned first curved edge and the second curved edge may be referred to the relevant descriptions in Fig. 1A, which will not be described again herein.

In some examples, as illustrated by Fig. 3, an extension direction of the first connection line CL1 of the first shape of the color filter 512 corresponding to the third color subpixel 230 in one of the two adjacent third color subpixel rows 237 is parallel to the row direction, and an extension direction of the first connection line CL1 of the first shape of the color filter 512 corresponding to the third color sub-pixel 230 in the other third color subpixel row 237 of the two adjacent third color subpixel rows 237 is parallel to the column direction, it can be further ensured that the display effect presented by the display substrate under different viewing angles is the same, thereby improving the display uniformity under different viewing angles.

In some examples, as illustrated by Fig. 3, one of the two first connection lines of the first shape of the color filter 512 corresponding to two third color sub-pixels 230 adjacent to one second color sub-pixel 220 is parallel to the row direction, and the other is parallel to the column direction.

In some examples, as illustrated by Fig. 3, a length of the first connection line of the first shape of the color filter 512 corresponding to the third color sub-pixel 230 is greater than a diameter of the color filter 512 corresponding to the first color sub-pixel 210 and a diameter of the color filter 512 corresponding to the second color sub-pixel 220. Of course, embodiments of the present disclosure include but are not limited thereto, the length of the first connection line of the first shape of the color filter corresponding to the third color sub-pixel may be smaller than the diameter of the color filter corresponding to the first color sub-pixel, and is larger than the diameter of the color filter corresponding to the second color sub-pixel.

In some examples, as illustrated by Fig. 3, centers of the plurality of third color sub-pixels 230 arranged in the first direction X are located on a straight line extending along the first direction X; and centers of the plurality of third color sub-pixels 230 arranged in the second direction Y are located on a straight line extending along the second direction Y. Of course, embodiments of the present disclosure include but are not limited thereto.

Fig. 4 is a planar schematic diagram of another display substrate provided by an embodiment of the present disclosure. As illustrated by Fig. 4, the display substrate 100 includes a base substrate 110 and a plurality of sub-pixels 200; the plurality of sub-pixels 200 are located on the base substrate 110; a shape of an orthographic projection of at least one sub-pixel 200 on the base substrate 110 includes a first shape 310, and the first shape 310 includes a first curved edge 311 and a second curved edge 312; two ends of the first curved edge 311 and the second curved edge 312 are respectively connected to form a first connection point P 1 and a second connection point P2. A length of the first connection line CL1 between the first connection point P1 and the second connection point P2 is a maximum length of the first shape 310 in an extension direction of the first connection line CL1, the first shape 310 is divided by the first connection line CL1 into a first sub-part 310A including a first curved edge 311 and a second sub-part 310B including a second curved edge 312; an area of the first sub-portion 310A is greater than an area of the second sub-portion 310B, a maximum vertical distance between each point on the first curved edge 311 and the first connection line CL1 is greater than a maximum vertical distance between each point on the second curved edge 312 and the first connection line CL1.

As illustrated by Fig. 4, in the first shape 310, the first curved edge 311 is a continuously curved edge, the second curved edge 312 includes a first sub-curved edge 312A, a second sub-curved edge 312B and a first straight edge 312C, the first straight edge 312C is connected with the first sub-curved edge 312A and the second sub-curved edge 312B respectively. In this way, the display substrate can also avoid color separation to a certain extent. In addition, the display substrate can flexibly adjust the size and distance of different sub-pixels according to the luminous efficiency and color index of different color sub-pixels by setting the above-mentioned first curved edge and the second curved edge including the first straight edge, to achieve a better display effect. In addition, the display substrate can further form spacers, fingerprint recognition units, photosensitive devices and other functional components at positions where the first straight edge is away from the first curved edge, so that other functions can be better integrated on the display substrate.

In some examples, as illustrated by Fig. 4, the plurality of sub-pixels 200 includes first color sub-pixels 210, second color sub-pixels 220, and third color sub-pixels 230; the first color sub-pixels 210 are configured to emit light of a first color, the second color sub-pixels 220 are configured to emit light of a second color, and the third color sub-pixels 230 are configured to emit light of a third color; a shape of an orthographic projection of each of the third color sub-pixels 230 on the base substrate 110 is a first shape 310; a plurality of third color sub-pixels 230 are arranged in an array along the row direction and the column direction to form third color sub-pixel rows 237 extending along the row direction, a plurality of third color sub-pixel rows 237 are arranged sequentially along the column direction; a first curved edge 311 and a second curved edge 312 of the first shape 310 have an arrangement order in a direction perpendicular to the first connection line CL1, in a same third color sub-pixel row 237, two adjacent third color sub-pixels 230 are arranged in opposite order. Therefore, in a same third color sub-pixel row, a distribution of third color sub-pixels with different arrangement orders is relatively uniform. Therefore, it can be ensured that the display effect presented by the display substrate under different viewing angles is the same, to improve the display uniformity under different viewing angles.

In some examples, as illustrated by Fig. 4, an area of each of the third color sub-pixels 230 is larger than an area of each of the first color sub-pixels 210, and the area of each of the third color sub-pixel 230 is larger than an area of each of the second color sub-pixels 210. By setting the area of the sub-pixel with a lower light emitting lifetime to be larger, the service life of the sub-pixel with a lower light emitting lifetime can be increased, thereby balancing the service life of different sub-pixels.

For example, the first color may be red, the second color may be green, and the third color may be blue. Of course, embodiments of the present disclosure include but are not limited thereto, and the first color, the second color and the third color can also be other colors.

In some examples, as illustrated by Fig. 4, the arrangement order of the first curved edge 311 and the second curved edge 312 includes a first order and a second order that are opposite to each other, in a same third color sub-pixel row 237, difference between a number of third color sub-pixels 230 in the first order and a number of third color sub-pixels 230 in the second order is less than 10. In this way, distribution of the third color sub-pixels with different arrangement orders is relatively uniform, Therefore, it can be ensured that the display effect presented by the display substrate under different viewing angles is the same, to improve the display uniformity under different viewing angles.

For example, in a same third color sub-pixel row 237, the difference between the number of third color sub-pixels 230 in the first order and the number of third color sub-pixels 230 in the second order is less than 2, thus the distribution of the third color sub-pixels with different arrangement orders is made more uniform.

For example, as illustrated by Fig. 4, in the same third color sub-pixel row 237, a first curved edge 311 and a second curved edge 312 in the first shape 310 of one of the two adjacent third color sub-pixels 230 may be sequentially arranged in the direction from left to right in Fig. 4, a first curved edge 311 and a second curved edge 312 in the first shape 310 of the other third color subpixel 230 of the two adjacent third color subpixels 230 may be arranged sequentially from right to left in Fig. 4. For another example, as illustrated by Fig. 4, in the same third color sub-pixel row 237, a first curved edge 311 and a second curved edge 312 in the first shape 310 of one of the two adjacent third color subpixels 230 may be sequentially arranged from top to bottom in Fig. 4, a first curved edge 311 and a second curved edge 312 in the first shape 310 of the other third color subpixel 230 of the two adjacent third color subpixels 230 may be arranged sequentially from bottom to top in Fig. 4.

In some examples, as illustrated by Fig. 4, an extension direction of a first connection line CL1 of the first shape 310 of the third color sub-pixel 230 in one of the two adjacent third-color sub-pixel rows 237 is parallel to the row direction, and an extension direction of a first connection line CL1 of the first shape 310 of the third color sub-pixel 230 in the other third color sub-pixel row 237 of the two adjacent third color sub-pixel rows 237 is parallel to the column direction. In this way, the display substrate sets the extension direction of the first connection line of the third color sub-pixel in two adjacent third-color sub-pixel rows to be parallel to the row direction and the column direction respectively. Therefore, it can be further ensured that the display substrate presents the same display effect under different viewing angles. Furthermore, the display uniformity under different viewing angles is improved.

In some examples, as illustrated by Fig. 4, the first straight edge 312C may be parallel to the first connection line CL1. Of course, embodiments of the present disclosure include but are not limited thereto, and the first straight edge may not be parallel to the first connecting line.

In some examples, as illustrated by Fig. 4, the first shape 310 may be a circular part with a larger area formed after being cut by the first straight line 312C. In this case, curvatures of all the points on the first curved edge 311 are the same, curvatures of all the points on the first sub-curved edge 312A are the same, and curvatures of all the points on the second sub-curved edge 312B are the same. Of course, embodiments of the present disclosure include but are not limited thereto.

In some examples, as illustrated by Fig. 4, the curvatures of all the points on the first curved edge 311, the curvatures of all the points on the first sub-curved edge 3 12A, and the curvatures of all the points on the second sub-curved edge 312B are the same.

In some examples, at least half of the first curved edge has the same curvature. In some examples, at least half of the sides on the first sub-curved edge have the same curvature. In some examples, at least half of the sides on the second sub-curved edge have the same curvature. In some examples, at least half of the second curved edges have the same curvature.

In some examples, as illustrated by Fig. 4, a shape of the first color sub-pixel 210 may be circular, and a shape of the second color sub-pixel 220 may be an ellipse. Of course, embodiments of the present disclosure include but are not limited thereto, the shape of the first color sub-pixel and the shape of the second color sub-pixel may also be other shapes.

In some examples, as illustrated by Fig. 4, an angle between an extension direction of a major axis of an ellipse of the second color sub-pixel 220 and the first direction X or the second direction Y is less than 90 degrees, for example, from 30 degrees to 60 degrees. Of course, embodiments of the present disclosure include but are not limited thereto, and the major axis of the ellipse of the second color sub-pixel may also extend along the first direction or the second direction.

In some examples, as illustrated by Fig. 4, a size of the ellipse of the second color sub-pixel 220 in the long axis direction is substantially equal to a diameter of the circular shape of the first color sub-pixel 210.

In some examples, as illustrated by Fig. 4, the display substrate 100 may be an array substrate for display, a stacking relationship between an anode, a pixel defining layer and a light emitting functional layer in the array substrate in a direction perpendicular to the base substrate can be seen in the relevant descriptions of Fig. 2. Of course, the embodiments of the present disclosure include but are not limited thereto, and the display substrate may also be a color filter substrate, please refer to the relevant descriptions in Fig. 3.

In some examples, as illustrated by Fig. 4, in a sub-pixel 230 having a first shape 310, a shape of an orthographic projection of a light emitting part 195 on the base substrate 110 is a rounded rectangle 350, the rounded rectangle 350 includes a first rounded corner part 351 and a second rounded corner part 352 arranged oppositely, the first rounded part 350 is located at a side of the first curved edge 311 away from the second curved edge 312, the second rounded part 352 is located at a side of the second curved edge 312 away from the first curved edge 311; a distance between a first vertex 351P of the first rounded part 351 away from a pixel opening 185 and the first curved edge 311 is smaller than a distance between a second vertex 352P of the second rounded part 352 away from the pixel opening 185 and the first straight edge 312C. In this way, the space at the position of the first straight edge away from the first curved edge is larger, the display substrate can form a spacer, a fingerprint recognition unit, a photosensitive device and other functional components at a position where the first straight edge is away from the first curved edge, thus other functions can be better integrated on the display substrate.

In some examples, as illustrated by Fig. 4, in the sub-pixel 230 having the first shape 310, The rounded rectangle 350 also includes a third rounded corner portion 353 and a fourth rounded corner portion 354 arranged oppositely, a line connecting a third vertex 353P of the third rounded corner part 353 away from the pixel opening 185 and the fourth vertex 354P of the fourth rounded corner part 354 away from the pixel opening 185 is substantially parallel to the first connection line CL1.

In some examples, as illustrated by Fig. 4, the plurality of sub-pixels 200 includes a plurality of sub-pixel groups 260, each of the plurality of sub-pixel groups 260 includes one first color sub-pixel 210, two second color sub-pixels 220 and one third color sub-pixel 230; in each of the sub-pixel groups 260, the first color sub-pixel 210 and the third color sub-pixel 230 are arranged along the first direction X, the two second color sub-pixels 220 are arranged along the second direction, a line connecting centers of the first color sub-pixel 210 and the third color sub-pixel 230 is intersected with a line connecting centers of the two second color sub-pixels 220. When the display substrate provided in the present example is used for display, two second color sub-pixels 220 in a pixel group may form two independent light emitting pixel points with a first color sub-pixel 210 and a third color sub-pixel 230 respectively, thus higher resolution is achieved through the principle of pixel borrowing.

In some examples, as illustrated by Fig. 4, a plurality of first color sub-pixels 210 and a plurality of third color sub-pixels 230 may be alternately arranged along the first direction X, and form first sub-pixel rows 270; a plurality of second color sub-pixels 220 may be arranged along the first direction X, and form second sub-pixel rows 280; and the plurality of first sub-pixel rows 270 and the plurality of second sub-pixel rows 280 are alternately arranged along the second direction.

In some examples, as illustrated by Fig. 4, in a first subpixel row 270, a line connecting centers of the first color sub-pixels 210 is a straight line, and a line connecting centers of the third color sub-pixels 230 is a polyline, and the straight line is intersected with the polyline. Of course, embodiments of the present disclosure include but are not limited thereto, and the line connecting the centers of the third color sub-pixel may also be a straight line.

In some examples, as illustrated by Fig. 4, in the second sub-pixel row 280, the line connecting the centers of the second color sub-pixels 220 is a straight line. Of course, embodiments of the present disclosure include but are not limited thereto, and the line connecting the centers of the third color sub-pixels may also be a polyline. In some examples, as illustrated by Fig. 4, the first straight edge 312C may be generally parallel to the second direction. Of course, embodiments of the present disclosure include but are not limited thereto, and the first straight edge may not be parallel to the second direction.

In some examples, as illustrated by Fig. 4, in the same second sub-pixel row 280, the long axes of the ellipses of two adjacent second color sub-pixels 220 are axially symmetrical, for example, are axially symmetrical with respect to the second direction. For example, in the same second sub-pixel row 280, an included angle between the extension lines of the long axes of the ellipses of two adjacent second color sub-pixels 220 ranges from 80 to 100 degrees.

In some examples, as illustrated by Fig. 4, in two adjacent second sub-pixel rows 280, the long axes of the ellipses of two adjacent second color sub-pixels 220 in the second direction are axially symmetrical or mirror symmetrical, for example, are axis symmetry or mirror symmetry with respect to the first direction X. For example, in the same second sub-pixel row 280, an included angle between the extension lines of the long axes of the ellipses of two adjacent second color sub-pixels 220 in the second direction Y ranges from 80 degrees to 100 degrees.

In some examples, as illustrated by Fig. 4, in each of the sub-pixel groups 260, the first center connection line and the second center connection line between the center of the first color sub-pixel 210 and the centers of the two second color sub-pixels 220 and the third center connection line and the fourth center connection line of the center of the third color sub-pixel 230 and the centers of the two second color sub-pixels 220 form a first virtual quadrilateral, at least one interior angle of the first virtual quadrilateral is not equal to 90 degrees. In this way, the display substrate can flexibly adjust the size and distance of different sub-pixels according to the light emitting efficiency and color indicators of different color sub-pixels, to achieve a better display effect. It should be noted that, for the sake of clarity, Fig. 4 does not show the reference numbers of all of the lines connecting centers, and the reference numbers of the above-mentioned first center connection line, second center connection line, third center connection line and fourth center connection line can be seen in Fig. 1A.

In some examples, as illustrated by Fig. 4, a value range of an interior angle of the above-mentioned first virtual quadrilateral 480 is from 84 degrees to 94 degrees. For example, one interior angle of the above-mentioned virtual quadrilateral may be 92 degrees.

In some examples, as illustrated by Fig. 4, lines connecting centers of the two first color sub-pixels 210 and centers of the two third color sub-pixels 230 in the two adjacent subpixel groups 260 in the second direction Y may form a second virtual quadrilateral, at least one interior angle of the second virtual quadrilateral is not equal to 90 degrees. In this way, the display substrate can flexibly adjust the size and distance of different sub-pixels according to the luminous efficiency and color indicators of different color sub-pixels, to achieve a better display effect. It should be noted that, for the sake of clarity, Fig. 4 does not show reference numerals of the second virtual quadrilateral, and the reference numbers of the above-mentioned second virtual quadrilateral can be seen in Fig. 1A.

In some examples, as illustrated by Fig. 4, in each of the sub-pixel groups 260, the first color sub-pixel 210 and the two second color sub-pixels 220 have a first distance D1 and a second distance D2 respectively, the third color sub-pixel 230 and the two second color sub-pixels 220 have a third distance D3 and a fourth distance D4 respectively; at least two of the first distance D1, the second distance D2, the third distance D3 and the fourth distance D4 are equal in size. In this way, the display substrate can ensure that each sub-pixel is evenly distributed, thereby increasing the pixel density while making full use of process accuracy.

In some examples, as illustrated by Fig. 4, the first distance D1, the second distance D2, the third distance D3 and the fourth distance D4 are all equal, to further ensure that each of the sub-pixels is evenly distributed, thus the pixel density can be further improved while making full use of process accuracy.

In some examples, as illustrated by Fig. 4, a fifth distance D5 between the first straight edge 312C of the third color sub-pixel 230 and the adjacent first color sub-pixel 210 may be greater than the above-mentioned first distance D1, second distance D2, third distance D3 and fourth distance D4 respectively.

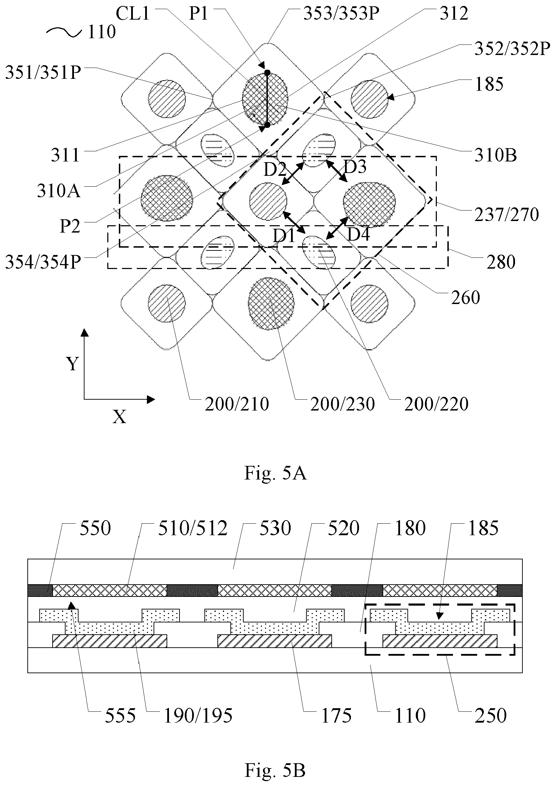

Fig. 5A is a planar schematic diagram of another display substrate provided by an embodiment of the present disclosure. As illustrated by Fig. 5A, the display substrate 100 includes a base substrate 110 and a plurality of sub-pixels 200; the plurality of sub-pixels 200 are located on the base substrate 110; a shape of an orthographic projection of at least one sub-pixel 200 on the base substrate 110 includes a first shape 310, the first shape 310 includes a first curved edge 311 and a second curved edge 312; two ends of the first curved edge 311 and the second curved edge 312 are respectively connected to form a first connection point P1 and a second connection point P2. A length of the first connection line CL1 between the first connection point P1 and the second connection point P2 is a maximum length of the first shape 310 in an extension direction of the first connection line CL1, the first shape 310 is divided by the first connection line CL1 into a first sub-part 310A including a first curved edge 311 and a second sub-part 310B including a second curved edge 312; an area of the first sub-part 310A is greater than an area of the second sub-part 310B, and a maximum vertical distance between each point on the first curved edge 311 and the first connection line CL1 is greater than a maximum vertical distance between each point on the second curved edge 312 and the first connection line CL1.

The first shape 310 shown in Fig. 5A is the same as the first shape 310 shown in Fig. 1A, that is, the first curved edge 311 of the first shape 310 is a continuously curved edge, and the second curved edge 312 of the first shape 310 is also a continuously curved edge. In this way, the display substrate can also avoid color separation to a certain extent, the display substrate can also flexibly adjust the size and distance of different sub-pixels according to the luminous efficiency and color index of different color sub-pixels by setting the above-mentioned first curved edge and second curved edge, to achieve a better display effect. Moreover, the display substrate can also form spacers, fingerprint recognition units, photosensitive devices and other functional components at positions where the second curved edge is away from the first curved edge, thus other functions can be better integrated on the display substrate.

In some examples, as illustrated by Fig. 5A , the plurality of sub-pixels 200 include first color sub-pixels 210, second color sub-pixels 220, and third color sub-pixels 230; the first color sub-pixels 210 are configured to emit light of a first color, the second color sub-pixels 220 are configured to emit light of a second color, and the third color sub-pixels 230 are configured to emit light of a third color; a shape of an orthographic projection of the third color sub-pixel 230 on the base substrate 110 is a first shape 310; a plurality of third color sub-pixels 230 are arranged in an array along the row direction and the column direction to form third color sub-pixel rows 237 extending along the row direction, a plurality of third color sub-pixel rows 237 are arranged sequentially along the column direction; a first curved edge 311 and a second curved edge 312 of the first shape 310 have an arrangement order in a direction perpendicular to the first connection line CL1, in a same third color sub-pixel row 237, two adjacent third color sub-pixels 230 are arranged in opposite order. Therefore, in the same third color sub-pixel row, the distribution of third color sub-pixels with different arrangement orders is relatively uniform, therefore, it can be ensured that the display effect presented by the display substrate under different viewing angles is the same, to improve the display uniformity under different viewing angles.

In some examples, as illustrated by Fig. 5A, the shape of the first color sub-pixel 210 may be circular, and the shape of the second color sub-pixel 220 may be an ellipse. Of course, the embodiments of the present disclosure include but are not limited thereto, and the shape of the first color sub-pixel and the shape of the second color sub-pixel can also be other shapes.

In some examples, as illustrated by Fig. 5A, a size of an ellipse of the second color sub-pixel 220 in the long axis direction is substantially equal to a diameter of the circular shape of the first color sub-pixel 210.

In some examples, as illustrated by Fig. 5A, in a same second sub-pixel row 280, the long axes of the ellipses of two adjacent second color sub-pixels 220 are axially symmetrical or mirror symmetrical, for example, are axis symmetry or mirror symmetry with respect to the second direction Y. For example, in the same second sub-pixel row 280, an included angle between the extension lines of the long axes of the ellipses of two adjacent second color sub-pixels 220 ranges from 80 degrees to 100 degrees.

In some examples, as illustrated by Fig. 5A, in two adjacent second sub-pixel rows 280, the long axes of the ellipses of the two adjacent second color sub-pixels 220 in the second direction Y are axially symmetrical or mirror symmetrical, for example, are axis symmetry or mirror symmetry with respect to the first direction X. For example, in a same second sub-pixel row 280, an included angle between the extension lines of the long axes of the ellipses of two adjacent second color sub-pixels 220 in the second direction Y ranges from 80 degrees to 100 degrees.

In some examples, as illustrated by Fig. 5A, the display substrate 100 may be an array substrate for display, a stacking relationship between an anode, a pixel defining layer and a light emitting functional layer in the array substrate in the direction perpendicular to the base substrate can be seen in the relevant descriptions of Fig. 2. Of course, the embodiments of the present disclosure include but are not limited thereto, the display substrate may also be a color filter substrate, please refer to the relevant descriptions in Fig. 3.

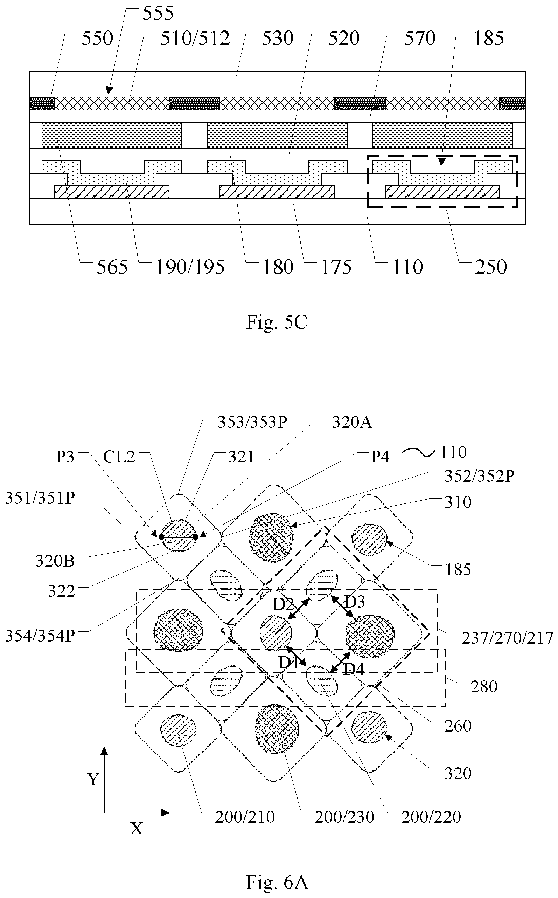

Fig. 5B is a cross-sectional schematic diagram of another display substrate provided by an embodiment of the present disclosure; and Fig. 5C is a cross-sectional schematic diagram of another display substrate provided by an embodiment of the present disclosure.

In some examples, as illustrated by Fig. 5B, the display substrate 100 further includes a plurality of anodes 175, a pixel defining layer 180, a light emitting functional layer 190, a color filter layer 510 and a black matrix 550; the plurality of anodes 175 are located on the base substrate 110; the pixel defining layer 180 is located on the base substrate 110; the light emitting functional layer 190 is located at a side of the plurality of anodes 175 and the pixel defining layer 180 away from the base substrate 110, a plurality of pixel openings 185 are arranged in the pixel defining layer 180, and the light emitting functional layer 190 includes a light emitting layer 192, the light emitting layer 192 includes a plurality of light emitting parts 195, the plurality of light emitting parts 195 are arranged in the plurality of pixel openings 185 and are driven and emit light by the plurality of anodes 175 exposed by the pixel openings 185, to form a plurality of light emitting structures 250 of a plurality of sub-pixels 200. The color filter layer 510 includes a plurality of color filters 512, the black matrix 550 is arranged between adjacent color filters 512, and the color filter 512 is arranged in a black matrix opening 555 of the black matrix 550. In this case, the display substrate may also define the shape of each of the sub-pixels by arranging a black matrix.

In some examples, as illustrated by Fig. 5B, a shape of an orthographic projection of the pixel opening 185 on the base substrate 110 and a shape of an orthogonal projection of the black matrix opening 555 on the base substrate 110 may be the same or different; and a center of the orthographic projection of the pixel opening 185 on the base substrate 110 and a center of the orthographic projection of the black matrix opening 555 on the base substrate 110 may or may not coincide with each other.

In some examples, the color filter and the black matrix are arranged at least partially overlapping. In some examples, the black matrix can also be formed by overlapping color filters of different colors.

In some examples, as illustrated by Fig. 5B, the display substrate 100 also includes an encapsulation layer 520 and a cover plate 530, the encapsulation layer 520 is located at a side of the light emitting functional layer 190 away from the base substrate 110, and the cover plate 530 is located at a side of the color filter layer 510 away from the base substrate 110. In this case, the color filter layer 510 is also formed on the encapsulation layer 520. Of course, embodiments of the present disclosure include but are not limited thereto, and the color filter layer may also be formed on the cover plate first and then is bonded to the packaging layer.

In some examples, as illustrated by Fig. 5C, the display substrate 100 includes a plurality of anodes 175, a pixel defining layer 180, a light emitting functional layer 190, a color conversion layer 365, a color filter layer 510 and a black matrix 550; the plurality of anodes 175 are located on the base substrate 110; the pixel defining layer 180 is located on the base substrate 110; the light emitting functional layer 190 is located at a side of the plurality of anodes 175 and the pixel defining layer 180 away from the base substrate 110, a plurality of pixel openings 185 are arranged in the pixel defining layer 180, and the light emitting functional layer 190 includes a light emitting layer 192, the light emitting layer 192 includes a plurality of light emitting parts 195, the plurality of light emitting portions 195 are arranged in the plurality of pixel openings 185 and are driven and emit light by the plurality of anodes 175 exposed by the plurality of pixel openings 185, to form a plurality of light emitting structures 250 of the plurality of sub-pixels 200. The color conversion layer 565 is arranged on a side of the light emitting part 195 away from the base substrate 110; the color filter layer 510 includes a plurality of color filters 512, the color filter 512 is arranged on a side of the color conversion layer 565 away from the light emitting part 195. In this way, the color conversion layer 565 can convert the light emitted by the light emitting structure 250 into light of a specific color, and then filtered by the corresponding color filter 512, thus it is possible to emit light of different colors with high color purity.

In some examples, the color conversion layer 565 may use a quantum dot layer; of course, the embodiments of the present disclosure include but are not limited thereto. The color conversion layer may also use other types of color conversion layers.

In some examples, as illustrated by Fig. 5C, the black matrix 550 is arranged between adjacent color filters 512, each of the color filters 512 is arranged in a black matrix opening 555 of the black matrix 550. In this case, the display substrate may also define the shapes of all the sub-pixels by arranging a black matrix.

In some examples, as illustrated by Fig. 5C, the display substrate 100 further includes an encapsulation layer 520, an optical adhesive layer 570 and a cover plate 530, the encapsulation layer 520 is located at a side of the light emitting functional layer 190 away from the base substrate 110, the color conversion layer 565 is arranged on a side of the encapsulation layer 520 away from the light emitting functional layer 190 and away from the base substrate 110; the optical adhesive layer 570 is arranged on a side of the color conversion layer 565 away from the base substrate 110, the color filter layer 510 is located at a side of the optical adhesive layer 570 away from the color conversion layer 565; and the cover plate 530 is located at a side of the color filter layer 510 away from the base substrate 110. In some examples, as illustrated by Fig. 5C, a size of an orthographic projection of the color conversion layer 565 on base substrate 110 is larger than a size of an orthographic projection of the pixel opening 185 on the base substrate 110; and a size of an orthographic projection of the black matrix opening 555 on the base substrate 110 is larger than the size of the orthographic projection of the pixel opening 185 on the base substrate 110.

In some examples, as illustrated by Fig. 5C, the size of the orthographic projection of the color conversion layer 565 on base substrate 110 is larger than the size of the orthographic projection of the black matrix opening 555 on the base substrate 110.

In some examples, as illustrated by Fig. 5A, in each of the sub-pixel groups 260, a first center connection line 410 and a second center connection line 420 between a center of the first color sub-pixel 210 and centers of the two second color sub-pixels 220 and a third center connection line 430 and a fourth center connection line 440 between a center of the third color sub-pixel 230 and centers of the two second color sub-pixels 220 form a first virtual quadrilateral 480, and at least one interior angle of the first virtual quadrilateral 480 is not equal to 90 degrees. In this way, the display substrate can flexibly adjust the size and distance of different sub-pixels according to the light emitting efficiency and color indicators of different color sub-pixels, to achieve a better display effect. It should be noted that, for the sake of clarity, Fig. 5A does not show the reference numbers of all the center connection lines, the reference numbers of the above-mentioned first center connection line, second center connection line, third center connection line and fourth center connection line can be seen in Fig. 1A.

In some examples, as illustrated by Fig. 5A, a range of an interior angle of the above-mentioned first virtual quadrilateral 480 is from 84 degrees to 94 degrees. For example, one interior angle of the above-mentioned virtual quadrilateral may be 92 degrees.

In some examples, as illustrated by Fig. 5A, lines connecting centers of the two first color sub-pixels 210 and centers of the two third color sub-pixels 230 in the two adjacent subpixel groups 260 in the second direction Y can form a second virtual quadrilateral 490, and at least one interior angle of the second virtual quadrilateral 490 is not equal to 90 degrees. In this way, the display substrate can better avoid the occurrence of color separation, can also flexibly adjust the size and distance of different sub-pixels according to the light emitting efficiency and color indicators of different color sub-pixels, to achieve a better display effect. It should be noted that, for the sake of clarity, Fig. 5A does not show the reference numerals of the second virtual quadrilateral, and the reference numbers of the above-mentioned second virtual quadrilateral can be seen in Fig. 1A.

In some examples, as illustrated by Fig. 5A, in each of the sub-pixel groups 260, the first color sub-pixel 210 and the two second color sub-pixels 220 have a first distance D1 and a second distance D2 respectively, the third color sub-pixel 230 and the two second color sub-pixels 220 have a third distance D3 and a fourth distance D4 respectively; at least two of the first distance D1, the second distance D2, the third distance D3 and the fourth distance D4 are equal in size. In this way, the display substrate can ensure that all the sub-pixels are evenly distributed, thus the pixel density can be increased while making full use of process accuracy.

In some examples, as illustrated by Fig. 5A, the first distance D1, the second distance D2, the third distance D3 and the fourth distance D4 are all equal, to further ensure that all the sub-pixels are evenly distributed, thus the pixel density can be further improved while making full use of process accuracy.

FIGS. 6A to 6B are planar schematic diagrams of another display substrate provided by an embodiment of the present disclosure. As illustrated by Fig. 6A, the display substrate 100 includes a base substrate 110 and a plurality of sub-pixels 200; the plurality of sub-pixels 200 are located on the base substrate 110; a shape of an orthographic projection of at least one sub-pixel 200 on the base substrate 110 includes a first shape 310, for a detailed description of the first shape 310, please refer to the relevant descriptions of Fig. 1A, which will not be described in detail herein.

As illustrated by Fig. 6A, the shape of the orthographic projection of at least one sub-pixels 200 on the base substrate 110 includes a second shape 320, the second shape 320 includes a third curved edge 321 and a fourth curved edge 322, two ends of the third curved edge 321 and two ends of the fourth curved edge 322 are respectively connected to form a third connection point P3 and a fourth connection point P4; a length of the second connection line CL2 between the third connection point P3 and the fourth connection point P4 is a maximum length of the second shape 320 in an extension direction of the second connection line CL2, the second shape 320 is divided by the second connection line CL2 into a third sub-part 320A including a third curved edge 321 and a fourth sub-part 320B including a fourth curved edge 322; an area of the third sub-section 320A is greater than an area of the fourth sub-section 320B, a maximum vertical distance between each point on the third curved edge 321 and the second connection line CL2 is greater than a maximum vertical distance between each point on the fourth curved edge 322 and the second connection line CL2. It should be noted that the above-mentioned maximum vertical distance between each point on the third curved edge and the second connection line refers to the largest one among a plurality of vertical distances between each point on the third curved edge and the second connection line, while the maximum vertical distance between each point on the fourth curved edge and the second connection line refers to the largest one of a plurality of vertical distances between each point on the fourth curved edge and the second connection line.

In the display substrate provided by the embodiment of the present disclosure, on the basis that the shape of the orthographic projection of at least one sub-pixel on the base substrate includes the first shape, the shape of the orthographic projection of at least one sub-pixel on the base substrate includes a second shape, and the second shape includes a third curved edge and a fourth curved edge, therefore, the shape of the orthographic projection of at least one sub-pixel on the base substrate is smoother, thus the occurrence of color separation can be reduced or even avoided. In addition, because the second shape is divided by the second connection line into a third sub-section including a third curved edge and a fourth sub-section including a fourth curved edge; an area of the third sub-section is greater than an area of the fourth sub-section, the maximum vertical distance between each point on the third curved edge and the second connection line is greater than the maximum vertical distance between each point on the fourth curved edge and the second connection line, therefore, the sub-pixels with the second shape can better avoid the color separation phenomenon. In addition, the display substrate can flexibly adjust the size and distance of different sub-pixels according to the light emitting efficiency and color index of different color sub-pixels by setting the above-mentioned third curved edge and fourth curved edge, to achieve a better display effect. In addition, the display substrate can also form spacers, fingerprint recognition units, photosensitive devices and other functional components at positions where the fourth curved edge is away from the third curved edge, thus other functions can be better integrated on the display substrate. In some examples, as illustrated by Fig. 6A, curvature of a vertex of the third curved edge 321 away from the second connection line CL2 is greater than curvature of a vertex of the fourth curved edge 322 away from the second connection line CL2.

In some examples, as illustrated by Fig. 6A, the third curved edge 321 is a continuously curved edge, and the fourth curved edge 322 is a continuously curved edge.

In some examples, as illustrated by Fig. 6A, a length of the second connection line CL2 is less than a length of the first connection line CL1. That is, the second shape is similar to the first shape, but the size of the second shape are smaller than the szie of the first shape.

In some examples, as illustrated by Fig. 6A , the plurality of sub-pixels 200 includes first color sub-pixels 210, second color sub-pixels 220, and third color sub-pixels 230; the first color sub-pixels 210 are configured to emit light of a first color, the second color sub-pixels 220 are configured to emit light of a second color, and the third color sub-pixels 230 are configured to emit light of a third color.

In some examples, as illustrated by Fig. 6A, an area of each of the third color sub-pixels 230 is larger than an area of each of the first color sub-pixels 210, the area of each of the third color sub-pixels 230 is larger than an area of each of the second color sub-pixels 210. By setting the area of each of the sub-pixels with a lower light emitting lifetime to be larger, the service life of the sub-pixel with a lower light emitting lifetime can be increased, thereby balancing the service life of different sub-pixels.

For example, the first color may be red, the second color may be green, and the third color may be blue. Of course, the embodiments of the present disclosure include but are not limited thereto, and the first color, the second color and the third color may also be other colors.

In some examples, as illustrated by Fig. 6A , the shape of the orthographic projection of the third color sub-pixel 230 on the base substrate 110 is a first shape 310; a plurality of third color sub-pixels 230 are arranged in an array along the row direction and the column direction to form third color sub-pixel rows 237 extending along the row direction, a plurality of third color sub-pixel rows 237 are arranged sequentially along the column direction; a first curved edge 311 and a second curved edge 312 of the first shape 310 have an arrangement order in a direction perpendicular to the first connection line CL1, in a same third color sub-pixel row 237, the arrangement order of two adjacent third color sub-pixels 230 is opposite; an extension direction of the first connecting line CL1 of the first shape 310 of the third color sub-pixel 230 in one of the two adjacent third-color sub-pixel rows 237 is parallel to the row direction, and an extension direction of the first connection line CL1 of the first shape 310 of the third color sub-pixel 230 in the other third color sub-pixel row 237 of the two adjacent third color sub-pixel rows 237 is parallel to the column direction. In this way, the display substrate can make the distribution of the third color sub-pixels with different arrangement orders more uniform, therefore, it can be ensured that the display effect presented by the display substrate is the same under different viewing angles, to improve display uniformity under different viewing angles. It should be noted that the arrangement order of the first curved edges and the second curved edges of the above-mentioned third color sub-pixels can be referred to the relevant descriptions in Fig. 1A, which will not be described in detail herein.

In some examples, as illustrated by Fig. 6A, a plurality of first color sub-pixels 210 are arranged in an array along the row direction and the column direction, to form first color sub-pixel rows 217 extending along the row direction, and a plurality of first color sub-pixel rows 217 are arranged sequentially along the column direction; a third curved edge 321 and a fourth curved edge 322 of the second shape 320 have an arrangement order in the direction perpendicular to the second connection line CL2, in a same first color sub-pixel row 217, arrangement orders of two adjacent first color sub-pixels 210 are opposite. For example, the first color sub-pixel row 217 and the third color sub-pixel row 237 may be a same sub-pixel row.

In the display substrate provided in the present example, because the two adjacent first color sub-pixels in the same first color sub-pixel row are arranged in opposite orders, in the same first color sub-pixel row, the distribution of first color sub-pixels with different arrangement orders is relatively uniform, therefore, it can be ensured that the display effect presented by the display substrate under different viewing angles is the same, to improve display uniformity under different viewing angles.

In some examples, as illustrated by Fig. 6A, the arrangement order of the third curved edge 321 and the fourth curved edge 322 includes a third order and a fourth order that are opposite to each other, in a same first color sub-pixel row 217, difference between a number of first color sub-pixels 210 having the third order and a number of first color sub-pixels 210 having the fourth order is less than 10. In this way, in the same first color sub-pixel row, the distribution of first color sub-pixels with different arrangement orders is relatively uniform, therefore, it can be ensured that the display effect presented by the display substrate under different viewing angles is the same, to improve display uniformity under different viewing angles.

For example, in the same first color sub-pixel row 217, the difference between the number of first color sub-pixels 210 with the third order and the number of first color sub-pixels 210 with the fourth order is less than 2, thus the first color sub-pixels with different arrangement orders are made more uniform.

For example, as illustrated by Fig. 6A, in a same first color sub-pixel row 217, a third curved edge 321 and a fourth curved edge 322 in the second shape 320 of one of the two adjacent first color sub-pixels 210 may be sequentially arranged in a direction from left to right in Fig. 6A, a third curved edge 321 and a fourth curved edge 322 in the second shape 320 of the other first color subpixel 210 of the two adjacent first color sub-pixels 210 may be sequentially arranged from right to left in Fig. 6A. For another example, as illustrated by Fig. 6A, in a same first color sub-pixel row 217, a third curved edge 321 and a fourth curved edge 322 in the second shape 320 of one of the two adjacent first color subpixels 210 may be sequentially arranged from top to bottom in Fig. 6A, and a third curved edge 321 and a fourth curved edge 322 in the second shape 320 of the other first color subpixel 210 of the two adjacent first color subpixels 210 may be arranged sequentially from bottom to top in Fig. 6A .

In some examples, as illustrated by Fig. 6A, an extension direction of a second connection line CL2 of a second shape 320 of a first color sub-pixel 210 in one of the two adjacent first-color sub-pixel rows 217 is parallel to the row direction, and an extension direction of a second connection line CL2 of a second shape 320 of a first color sub-pixel 210 in the other first color sub-pixel row 217 of the two adjacent first color sub-pixel rows 217 is parallel to the column direction. In this way, the display substrate sets the extension direction of the first connection line of the third color sub-pixel in two adjacent third-color sub-pixel rows to be parallel to the row direction and the column direction respectively, can further ensure that the display effect presented by the display substrate is the same under different viewing angles, and the display uniformity under different viewing angles is improved.

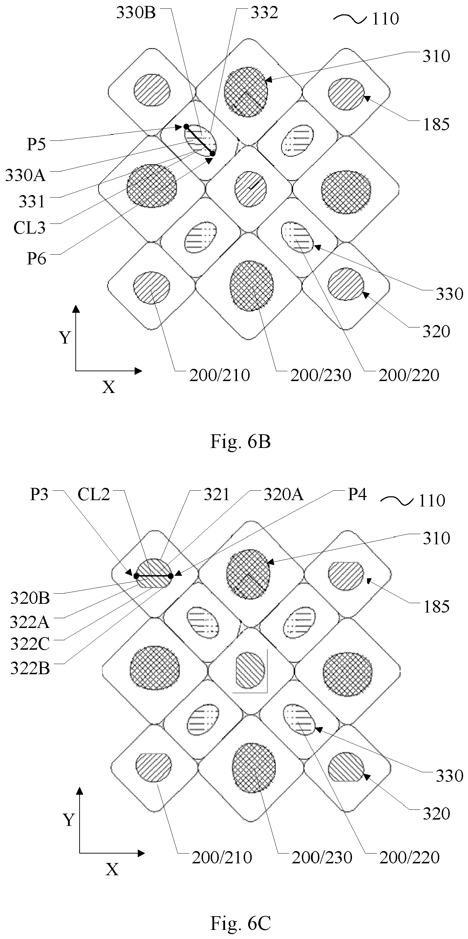

In some examples, as illustrated by Fig. 6B, a shape of an orthographic projection of at least one sub-pixel 200 on the base substrate 110 includes a third shape 330, the third shape 330 includes a fifth curved edge 331 and a sixth curved edge 332, two ends of the fifth curved edge 331 and two ends of the sixth curved edge 332 are respectively connected to form a fifth connection point P5 and a sixth connection point P6; a length of the third connection line CL3 between the fifth connection point P5 and the sixth connection point P6 is a maximum length of the third shape 330 in an extension direction of the third connection line CL3, the third shape 330 is divided by the third connection line CL3 into a fifth sub-section 330A including the fifth curved edge 331 and a sixth sub-section 330B including the sixth curved edge 332; an area of the fifth sub-section 330A is equal to an area of the sixth sub-section 330B, and the fifth curved edge 331 and the sixth curved edge 332 are arranged axially symmetrically with respect to the third connection line CL3. In this way, the shapes of the orthographic projections of the sub-pixels with the third shape on the base substrate are smoother, thus the occurrence of color separation can be reduced or even avoided. It should be noted that the display substrate shown in Fig. 6B is the same as the display substrate shown in Fig. 6A, in order to better illustrate the relevant features of the third color sub-pixels, other reference signs are omitted in Fig. 6B.

In some examples, as illustrated by Fig. 6B, the shape of the second color sub-pixel 220 may be an ellipse. Of course, the embodiments of the present disclosure include but are not limited thereto, and the shape of the second color sub-pixel may also be circular.

In some examples, as illustrated by Fig. 6B, the fifth curved edge 331 is a continuously curved edge, and the sixth curved edge 332 is a continuously curved edge.

In some examples, as illustrated by Fig. 6B, a length of the third connection line CL3 is less than a length of the first connection line CL1.

In some examples, as illustrated by FIGS. 6A and 6B, in a case that the plurality of sub-pixels 200 include first color sub-pixels 210, second color sub-pixels 220 and third color sub-pixels 230, a shape of an orthographic projection of each of the third color sub-pixels 230 on the base substrate 110 is a first shape 310, a shape of an orthographic projection of each of the first color sub-pixels 210 on the base substrate 110 is a second shape 320, and a shape of an orthographic projection of each of the second color sub-pixels 220 on the base substrate 110 is the third shape 330. In this way, the shapes of the orthographic projections of the first color sub-pixel, the second color sub-pixel and the third color sub-pixel on the base substrate are smoother, thus the occurrence of color separation can be reduced or even avoided.

In some examples, as illustrated by FIGS. 6A and 6B, the length of the third connection line CL3 is equal to a length of the second connection line CL2, that is, a length of a long axis of an ellipse of each of the second color sub-pixels 220 is equal to the length of the second connection line CL2.

In some examples, as illustrated by FIGS. 6A and 6B, the plurality of sub-pixels 200 includes a plurality of sub-pixel groups 260, each of the plurality of sub-pixel groups 260 includes one first color sub-pixel 210, two second color sub-pixels 220 and one third color sub-pixel 230; in each of the plurality of sub-pixel groups 260, the first color sub-pixel 210 and the third color sub-pixel 230 are arranged along the first direction X, the two second color sub-pixels 220 are arranged along the second direction Y, a line connecting a center of the first color sub-pixel 210 and a center of the third color sub-pixel 230 is intersected with a line connecting centers of the two second color sub-pixels 220. In a case that the display substrate provided in the present example is used for display, two second color sub-pixels 220 in a pixel group may form two independent light emitting pixel points with a first color sub-pixel 210 and a third color sub-pixel 230, respectively, thus higher resolution is achieved through the principle of pixel borrowing.

In some examples, as illustrated by FIGS. 6A and 6B, a plurality of first color sub-pixels 210 and a plurality of third color sub-pixels 230 may be alternately arranged along the first direction X and form first sub-pixel rows 270; the plurality of second color sub-pixels 220 may be arranged along the first direction X and form second sub-pixel rows 280; and a plurality of first sub-pixel rows 270 and a plurality of second sub-pixel rows 280 are alternately arranged along the second direction Y.

In some examples, as illustrated by FIGS. 6A and 6B, in a same second sub-pixel row 280, long axes of ellipses of two adjacent second color sub-pixels 220 are axially symmetrical, for example, are axially symmetrical with respect to the second direction Y. For example, in a same second sub-pixel row 280, an included angle between the extension lines of the long axes of the ellipses of two adjacent second color sub-pixels 220 ranges from 80 degrees to 100 degrees.

In some examples, as illustrated by FIGS. 6A and 6B, in two adjacent second sub-pixel rows 280, long axes of ellipses of two adjacent second color sub-pixels 220 in the second direction Y are axially symmetrical, for example, are axially symmetrical with respect to the first direction X. For example, in a same second sub-pixel row 280, an included angle between extension lines of the long axes of the ellipses of the two adjacent second color sub-pixels 220 in the second direction Y ranges from 80 degrees to 100 degrees.

In some examples, as illustrated by FIGS. 6A and 6B, the display substrate 100 may be an array substrate used for display, a stacking relationship between an anode, a pixel defining layer and a light emitting functional layer in the array substrate in the direction perpendicular to the base substrate can be seen in the relevant descriptions of Fig. 2. Of course, the embodiments of the present disclosure include but are not limited thereto, the display substrate may also be a color filter substrate, please refer to the relevant descriptions of Fig. 3.

In some examples, as illustrated by FIGS. 6A and 6B, in each of the sub-pixel groups 260, the first center connection line and the second center connection line between the center of the first color sub-pixel 210 and the centers of the two second color sub-pixels 220 and the third center connection line and the fourth center connection line between the center of the third color sub-pixel 230 and the centers of the two second color sub-pixels 220 form a first virtual quadrilateral, and at least one interior angle of the first virtual quadrilateral 480 is not equal to 90 degrees. In this way, this display substrate can better avoid the occurrence of color separation, and the display substrate can also flexibly adjust the size and distance of different sub-pixels according to the luminous efficiency and color indicators of different color sub-pixels, to achieve a better display effect.

It should be noted that, for the sake of clarity, FIGS. 6A and 6B do not show the reference numbers of all the central connection lines, and the reference numbers of the above-mentioned first center connection line, second center connection line, third center connection line and fourth center connection line can be seen in Fig. 1A.

In some examples, as illustrated by FIGS. 6A and 6B, a range of an interior angle of the above-mentioned first virtual quadrilateral 480 is from 84 degrees to 94 degrees. For example, an interior angle of the above-mentioned virtual quadrilateral may be 92 degrees.

In some examples, as illustrated by FIGS. 6A and 6B, lines connecting centers of the two first color sub-pixels 210 and centers of the two third color sub-pixels 230 in the two adjacent subpixel groups 260 in the second direction Y may form a second virtual quadrilateral 490, at least one interior angle of the second virtual quadrilateral 490 is not equal to 90 degrees. In this way, the display substrate can better avoid the occurrence of color separation, and the display substrate can also flexibly adjust the size and distance of different sub-pixels according to the light emitting efficiency and color indicators of different color sub-pixels, to achieve a better display effect. It should be noted that, for the sake of clarity, FIGS. 6A and 6B do not show the reference numerals of the second virtual quadrilateral, and the reference numbers of the above-mentioned second virtual quadrilateral can be seen in Fig. 1A.

In some examples, as illustrated by FIGS. 6A and 6B, in each of the sub-pixel groups 260, the first color sub-pixel 210 and the two second color sub-pixels 220 have a first distance D1 and a second distance D2 respectively, the third color sub-pixel 230 and the two second color sub-pixels 220 have a third distance D3 and a fourth distance D4 respectively; and at least two of the first distance D1, the second distance D2, the third distance D3 and the fourth distance D4 are equal in size. In this way, the display substrate can ensure that all the sub-pixels are evenly distributed, thus the pixel density can be increased while making full use of process accuracy.

In some examples, as illustrated by FIGS. 6A and 6B, the first distance D1, the second distance D2, the third distance D3 and the fourth distance D4 are all equal, to further ensure that each sub-pixel is evenly distributed, thus the pixel density can be further improved while making full use of process accuracy.

Fig. 6C is a planar schematic diagram of another display substrate provided by an embodiment of the present disclosure. As illustrated by Fig. 6C, similar to the first shape, the fourth curved edge 322 of the second shape 320 also includes a third sub-curved edge 322A, a fourth sub-curved edge 322B and a second straight edge 322C, and the second straight edge 322C is connected with the third sub-curved edge 322A and the fourth sub-curved edge 322C respectively. It should be noted that, for an arrangement of the third curved edge 321 and the fourth curved edge 322 of the second shape 320 of the first color sub-pixel 210 in Fig. 6C, please refer to the relevant descriptions of Fig. 6A.

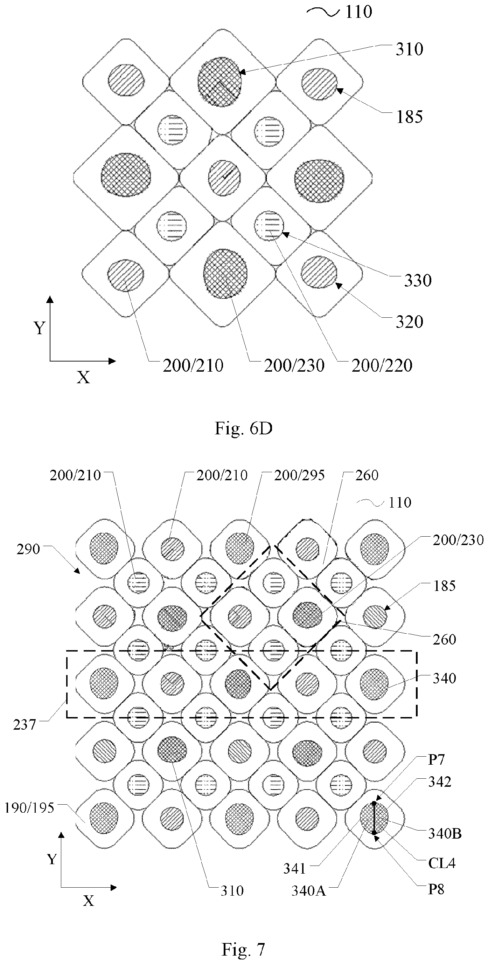

Fig. 6D is a planar schematic diagram of another display substrate provided by an embodiment of the present disclosure. As illustrated by Fig. 6D, a shape of an orthographic projection of a third color sub-pixel 230 on the base substrate 110 may be a first shape 310; a shape of an orthographic projection of a first color sub-pixel 210 on the base substrate 110 may be the above-mentioned second shape 320; and a shape of an orthographic projection of a second color sub-pixel 220 on the base substrate 110 may be circular. It should be noted that the above-mentioned first shape and second shape may have a same shape and size as the first shape and the second shape in any example in FIGS. 6A to 6C, and an arrangement of the first shape and the second shape mentioned above can also refer to the relevant descriptions in any one of the examples in FIGS. 6A to 6C.

Fig. 7 is a planar schematic diagram of another display substrate provided by an embodiment of the present disclosure. As illustrated by Fig. 7, the display substrate 100 includes a base substrate 110 and a plurality of sub-pixels 200; the plurality of sub-pixels 200 are located on the base substrate 110; a shape of an orthographic projection of at least one sub-pixel 200 on the base substrate 110 includes a first shape 310, for detailed description of the first shape 310, please refer to the relevant descriptions of Fig. 1A, which will not be described in detail herein.

As illustrated by Fig. 7, a plurality of sub-pixels 200 are arranged along an array on the base substrate 110 to form a display array 290, the plurality of sub-pixels 200 includes boundary sub-pixels 295 located at an edge of the display array 290, a shape of an orthographic projection of at least one boundary sub-pixel 295 on the base substrate 110 includes a fourth shape 340, the fourth shape 340 includes a seventh curved edge 341 and an eighth curved edge 342, two ends of the seventh curved edge 342 and two ends of the eighth curved edge 342 are respectively connected to form a seventh connection point P7 and an eighth connection point P8; a length of a fourth connection line CL4 between the seventh connection point P7 and the eighth connection point P8 is a maximum length of the fourth shape 340 in an extension direction of the fourth connection line CL4, the fourth shape 340 is divided by the fourth connection line CL4 into a seventh sub-section 340A including a seventh curved edge 341 and an eighth sub-section 340B including an eighth curved edge 342; an area of the seventh sub-section 340A is equal to an area of the eighth sub-section 340B, a shape of the seventh curved edge 341 is the same as a shape of the second curved edge 312, a shape of the eighth curved edge 342 is the same as a shape of the second curved edge 312. That is, relative to the first shape, both curved edges of the fourth shape are contracted.

In the display substrate provided in the present example, on the basis that the shape of the orthographic projection of at least one sub-pixel on the base substrate includes the first shape, because the shape of the orthographic projection of the boundary sub-pixel on the base substrate includes the fourth shape, and the fourth shape includes a seventh curved edge and an eighth curved edge, therefore, the shape of the orthographic projection of the boundary sub-pixel on the base substrate is smoother, thus the occurrence of color separation can be reduced or even avoided.

In some examples, as illustrated by Fig. 7, the seventh curved edge 341 is a continuously curved edge, and the eighth curved edge 342 is a continuously curved edge.

In some examples, as illustrated by Fig. 7, a length of the fourth connection line CL4 is equal to a length of the first connection line CL1. In this way, both the boundary sub-pixel 295 and the third color sub-pixel 230 are configured to emit light of a third color.

In some examples, as illustrated by Fig. 7, the display substrate 100 may be an array substrate for display, a stacking relationship between an anode, a pixel defining layer and a light emitting functional layer in the array substrate in the direction perpendicular to the base substrate can be seen in the relevant descriptions of Fig. 2. Of course, the embodiments of the present disclosure include but are not limited thereto, the display substrate may also be a color filter substrate, please refer to the relevant descriptions in Fig. 3.

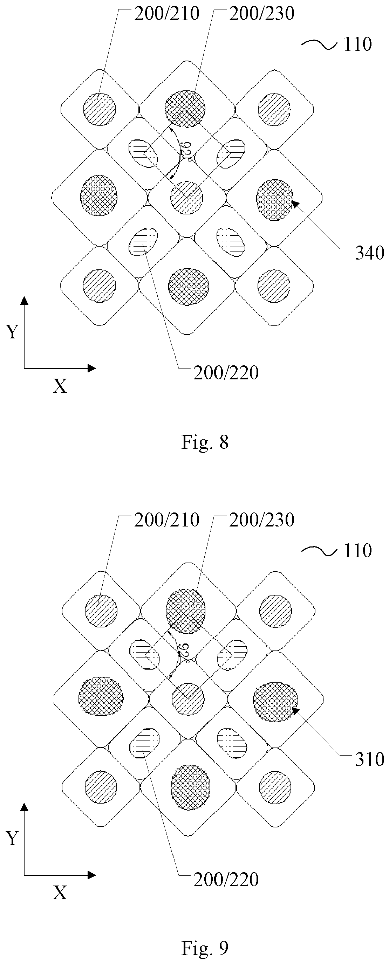

Fig. 8 is a planar schematic diagram of another display substrate provided by an embodiment of the present disclosure. As illustrated by Fig. 8, the display substrate 100 includes a base substrate 110 and a plurality of sub-pixels 200; the plurality of sub-pixels 200 are located on the base substrate 110; a shape of an orthographic projection of at least one sub-pixel 200 on the base substrate 110 includes a first shape 310, for detailed description of the first shape 310, please refer to the relevant descriptions of Fig. 1A, which will not be described in detail herein.

As illustrated by Fig. 8, the plurality of sub-pixels 200 include first color sub-pixels 210, second color sub-pixels 220 and third color sub-pixels 230; the first color sub-pixels 210 are configured to emit light of a first color, the second color sub-pixels 220 are configured to emit light of a second color, and the third color sub-pixels 230 are configured to emit light of a third color; a shape of an orthographic projection of each of the third color sub-pixels 230 on the base substrate 110 is the above-mentioned first shape 310; a shape of an orthographic projection of each of the first color sub-pixels 210 on the base substrate 110 is circular; and a shape of an orthographic projection of each of the second color sub-pixels 220 on the base substrate 110 is an ellipse.

Fig. 9 is a planar schematic diagram of another display substrate provided by an embodiment of the present disclosure. As illustrated by Fig. 9, the display substrate 100 includes a base substrate 110 and a plurality of sub-pixels 200; the plurality of sub-pixels 200 are located on the base substrate 110; a shape of an orthographic projection of at least one sub-pixel 200 on the base substrate 110 includes a first shape 310, for detailed description of the first shape 310, please refer to the relevant descriptions of Fig. 1A, which will not be described in detail herein.

As illustrated by Fig. 9, the plurality of sub-pixels 200 include first color sub-pixels 210, second color sub-pixels 220 and third color sub-pixels 230; the first color sub-pixels 210 are configured to emit light of the first color, the second color sub-pixels 220 are configured to emit light of the second color, and the third color sub-pixels 230 are configured to emit light of the third color; a shape of an orthographic projection of each of the third color sub-pixels 230 on the base substrate 110 is the above-mentioned first shape 310; a shape of an orthographic projection of each of the first color sub-pixels 210 on the base substrate 110 is circular; and a shape of an orthographic projection of the second color sub-pixel 220 on the base substrate 110 is a rounded rectangle. It should be noted that the above-mentioned rounded rectangle refers to a shape formed by rounding the four right corners of the rectangle.

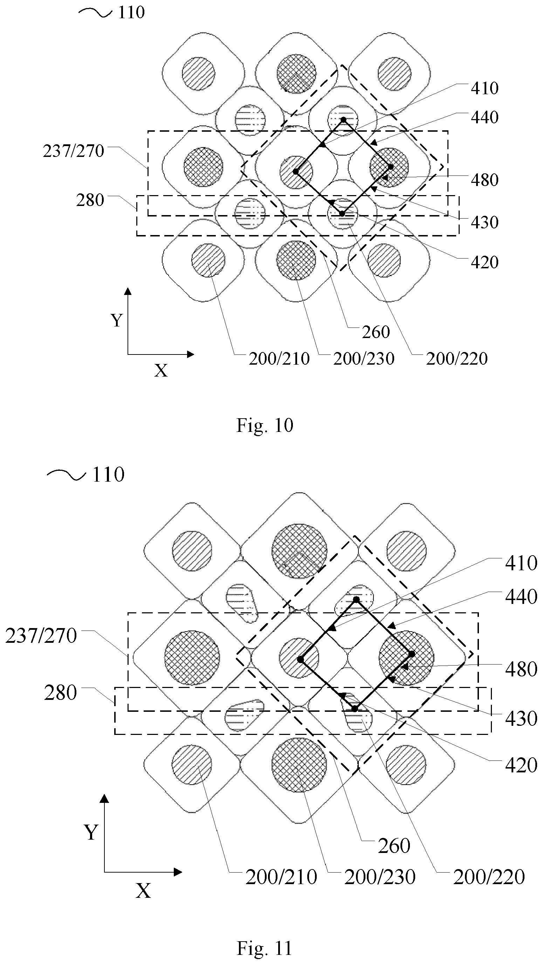

Fig. 10 is a planar schematic diagram of another display substrate provided by an embodiment of the present disclosure. As illustrated by Fig. 10, the display substrate 100 includes a base substrate 110 and a plurality of sub-pixels 200; the plurality of sub-pixels 200 are located on the base substrate 110; the plurality of sub-pixels 200 include a plurality of sub-pixel groups 260, each of the sub-pixel groups 260 includes one first color sub-pixel 210, two second color sub-pixels 220 and one third color sub-pixel 230; in each of the sub-pixel groups 260, the first color sub-pixel 210 and the third color sub-pixel 230 are arranged along the first direction X, the two second color sub-pixels 220 are arranged along the second direction Y, a line connecting centers of the first color sub-pixel 210 and the third color sub-pixel 230 is intersected with a line connecting centers of the two second color sub-pixels 220. In a case that the display substrate provided in the present example is used for display, two second color sub-pixels 220 in a pixel group may form two independent light emitting pixel points with the first color sub-pixel 210 and the third color sub-pixel 230, respectively, thus higher resolution is achieved through the principle of pixel borrowing.

As illustrated by FIG.10, in each of the sub-pixel groups 260, a first center connection line 410 and a second center connection line 420 between the center of the first color sub-pixel 210 and the centers of the two second color sub-pixels 220 and a third center connection line 430 and a fourth center connection line 440 between the center of the third color sub-pixel 230 and the centers of the two second color sub-pixels 220 form a first virtual quadrilateral 480, and at least one interior angle of the first virtual quadrilateral 480 is not equal to 90 degrees. In this way, the display substrate can better avoid the occurrence of color separation, and the display substrate also flexibly adjusts the size and distance of different sub-pixels according to the luminous efficiency and color indicators of different color sub-pixels, to achieve a better display effect.

In some examples, as illustrated by Fig. 10, a range of an interior angle of the above-mentioned first virtual quadrilateral 480 is from 84 degrees to 94 degrees. For example, one interior angle of the above-mentioned virtual quadrilateral may be 93 degrees.

In some examples, as illustrated by Fig. 10, a shape of an orthographic projection of the first color sub-pixel 210 on the base substrate 110 is circular; a shape of an orthographic projection of the second color sub-pixel 220 on the base substrate 110 is circular, and a shape of an orthographic projection of the third color sub-pixel 230 on the base substrate 110 is circular.

Fig. 11 is a planar schematic diagram of another display substrate provided by an embodiment of the present disclosure. As illustrated by Fig. 11, the display substrate 100 includes a base substrate 110 and a plurality of sub-pixels 200; the plurality of sub-pixels 200 are located on the base substrate 110 and adopt a certain pixel arrangement to perform light emitting display. For a pixel arrangement of the plurality of sub-pixels 200, please refer to the relevant descriptions of Fig. 11, which will not be described in detail herein.

As illustrated by Fig. 11, in each of the sub-pixel groups 260, a first center connection line 410 and a second center connection line 420 between the center of the first color sub-pixel 210 and the centers of the two second color sub-pixels 220 and a third center connection line 430 and a fourth center connection line 440 between the center of the third color sub-pixel 230 and the centers of the two second color sub-pixels 220 form a first virtual quadrilateral 480, and at least one interior angle of the first virtual quadrilateral 480 is not equal to 90 degrees. In this way, the display substrate can better avoid the occurrence of color separation, and the display substrate can also flexibly adjust the size and distance of different sub-pixels according to the light emitting efficiency and color indicators of different color sub-pixels, to achieve a better display effect.

In some examples, as illustrated by Fig. 11, a shape of an orthographic projection of a first color sub-pixel 210 on the base substrate 110 is circular; a shape of an orthographic projection of a second color sub-pixel 220 on the base substrate 110 is a water drop shape, and a shape of an orthographic projection of a third color sub-pixel 230 on the base substrate 110 is circular. It should be noted that the sizes of two ends of the above-mentioned water drop shape in its long axis direction are not equal.

In some examples, as illustrated by Fig. 11, a range of an interior angle of the above-mentioned first virtual quadrilateral 480 is from 84 degrees to 94 degrees. For example, one interior angle of the above-mentioned virtual quadrilateral may be 85 degrees.

In some examples, as illustrated by Fig. 11, an extension line of the long axis of the water drop shape of the second color sub-pixel 220 passes through the adjacent first color sub-pixel 210, and is not parallel to a line connecting a center of the second color sub-pixel 220 and a center of the first color sub-pixel 210.

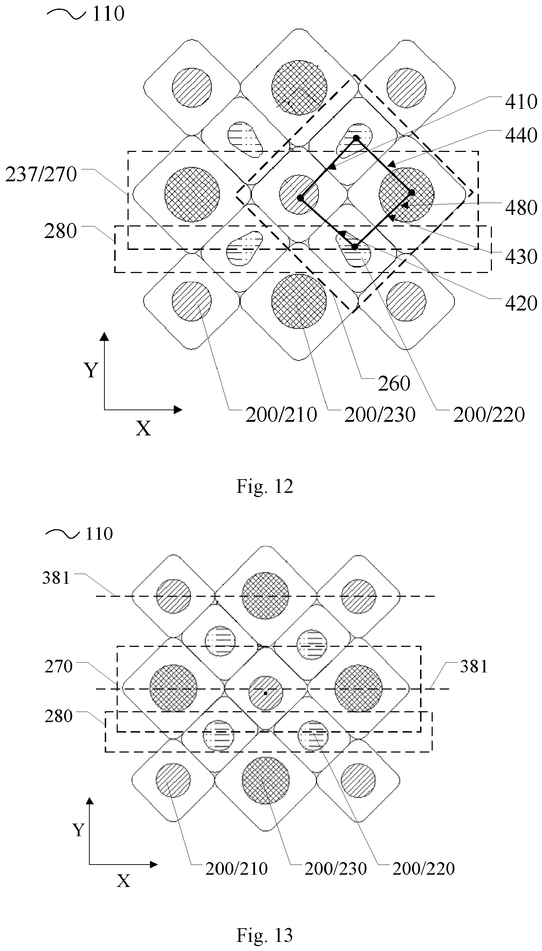

Fig. 12 is a planar schematic diagram of another display substrate provided by an embodiment of the present disclosure. As illustrated by Fig. 12, the display substrate 100 includes a base substrate 110 and a plurality of sub-pixels 200; the plurality of sub-pixels 200 are located on the base substrate 110 and adopt a certain pixel arrangement to perform light emitting display. For the pixel arrangement of the plurality of sub-pixels 200, please refer to the relevant descriptions of Fig. 11, which will not be described in detail herein.

As illustrated by Fig. 12, in each of the sub-pixel groups 260, a first center connection line 410 and a second center connection line 420 between the center of the first color sub-pixel 210 and the centers of the two second color sub-pixels 220 and a third center connection line 430 and a fourth center connection line 440 between the center of the third color sub-pixel 230 and the centers of the two second color sub-pixels 220 form a first virtual quadrilateral 480, and at least one interior angle of the first virtual quadrilateral 480 is not equal to 90 degrees. For example, one interior angle of the above-mentioned virtual quadrilateral may be 86 degrees.

In some examples, as illustrated by Fig. 12, an extension line of a long axis of a water drop shape of a second color sub-pixel 220 passes through the adjacent first color sub-pixel 210, and is parallel to a line connecting a center of the second color sub-pixel 220 and a center of the first color sub-pixel 210.

Fig. 13 is a planar schematic diagram of another display substrate provided by an embodiment of the present disclosure. As illustrated by Fig. 13, the display substrate 100 includes a base substrate 110 and a plurality of sub-pixels 200; and the plurality of sub-pixels 200 are located on the base substrate 110 and adopt a certain pixel arrangement to perform light emitting display. The plurality of sub-pixels 200 include first color sub-pixels 210, second color sub-pixels 220 and third color sub-pixels 230. The plurality of first color sub-pixels 210 and the plurality of third color sub-pixels 230 may be alternately arranged along the first direction X, and form first sub-pixel rows 270; the plurality of second color sub-pixels 220 may be arranged along the first direction X, and form second sub-pixel rows 280; a plurality of first sub-pixel rows 270 and a plurality of second sub-pixel rows 280 are alternately arranged along the second direction. In each of the first sub-pixel rows 270, a center of an orthographic projection of each of the plurality of third color sub-pixels 230 on the base substrate 110 is located on a first virtual straight line 381 extending along the first direction X. In at least one first sub-pixel row 270, a center of an orthographic projection of each of the first color sub-pixels 210 on the base substrate 110 is located on one side of the first virtual straight line 381 in the second direction Y.

In some examples, as illustrated by Fig. 13, the center of the orthographic projection of each of the first color sub-pixels 210 on the base substrate 110 is spaced apart from the first virtual straight line 381, that is, a distance between the orthographic projection of the first color sub-pixel 210 on the base substrate 110 and the first virtual straight line 381 is greater than 0.

In some examples, as illustrated by Fig. 13, in two adjacent first sub-pixel rows 270 in the second direction Y, a center of an orthographic projection of each of the first color sub-pixels 210 in a first sub-pixel row 270 on the base substrate 110 is spaced apart from a first virtual straight line 381 of the row, and a center of an orthographic projection of each of the first color sub-pixels 210 in another first sub-pixel row 270 on the base substrate 110 is located on the first virtual straight line 381 of the row.

In some examples, as illustrated by Fig. 13, a shape of an orthographic projection of each of the first color sub-pixels 210 on the base substrate 110 is circular, a shape of an orthographic projection of each of the second color sub-pixels 220 on the base substrate 110 is circular, and a shape of an orthographic projection of each of the third color sub-pixels 230 on the base substrate 110 is circular.

In some examples, as illustrated by Fig. 13, a diameter of the orthographic projection shape of each of the third color sub-pixels 230 on the base substrate 110 is larger than a diameter of the shape of the orthographic projection of each of the first color sub-pixel 220 on the base substrate 110; and the diameter of the orthographic projection shape of the first color sub-pixel 210 on the base substrate 110 is larger than a diameter of the shape of the orthographic projection of each of the second color sub-pixel 220 on the base substrate 110.

In some examples, as illustrated by Fig. 13, the plurality of sub-pixels 200 includes a plurality of sub-pixel groups 260, each of the plurality of sub-pixel groups 260 includes one first color sub-pixel 210, two second color sub-pixels 220 and one third color sub-pixel 230; in each of the sub-pixel groups 260, the first color sub-pixel 210 and the third color sub-pixel 230 are arranged along the first direction X, the two second color sub-pixels 220 are arranged along the second direction Y, a line connecting a center of the first color sub-pixel 210 and a center of the third color sub-pixel 230 is intersected with a line connecting centers of the two second color sub-pixels 220. Lines connecting centers of the two first color sub-pixels 210 and centers of the two third color sub-pixels 230 in the two adjacent sub-pixel groups 260 in the second direction Y can form a second virtual quadrilateral, and the second virtual quadrilateral is a right-angled trapezoid.

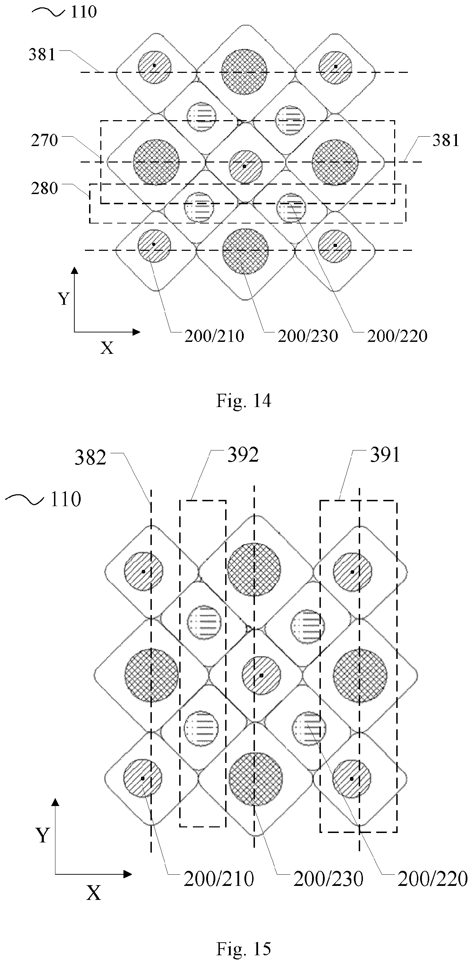

Fig. 14 is a planar schematic diagram of another display substrate provided by an embodiment of the present disclosure. As illustrated by Fig. 14, the display substrate 100 includes a base substrate 110 and a plurality of sub-pixels 200; the plurality of sub-pixels 200 are located on the base substrate 110, and adopt a certain pixel arrangement to perform light emitting display. The plurality of sub-pixels 200 include first color sub-pixels 210, second color sub-pixels 220 and third color sub-pixels 230. A plurality of first color sub-pixels 210 and a plurality of third color sub-pixels 230 may be alternately arranged along the first direction X, and form first sub-pixel rows 270; a plurality of second color sub-pixels 220 may be arranged along the first direction X and form second sub-pixel rows 280; a plurality of first sub-pixel rows 270 and a plurality of second sub-pixel rows 280 are alternately arranged along the second direction. In each of the first sub-pixel rows 270, a center of an orthographic projection of each of the plurality of third color sub-pixels 230 on the base substrate 110 is located on the first virtual straight line 381 extending along the first direction X, and a center of the orthographic projection of each of the first color sub-pixels 210 on the base substrate 110 is located on one side of a first virtual straight line 381 in the second direction Y.

In some examples, as illustrated by Fig. 14, the center of the orthographic projection of each of the first color sub-pixels 210 on the base substrate 110 is spaced apart from a first virtual straight line 381, that is, a distance between the orthographic projection of each of the first color sub-pixels 210 on the base substrate 110 and the first virtual straight line 381 is greater than 0.

In some examples, as illustrated by Fig. 14, in two adjacent first sub-pixel rows 270 in the second direction Y, a center of an orthographic projection of each of the first color sub-pixels 210 in a first sub-pixel row 270 on the base substrate 110 is located on a first side of the first virtual straight line 381 of the row in the second direction Y, and a center of an orthographic projection of each of the first color sub-pixels 210 in another first sub-pixel row 270 on the base substrate 110 is located on a second side of the first virtual straight line 381 of the row in the second direction Y.

In some examples, as illustrated by Fig. 14, a shape of the orthographic projection of each of the first color sub-pixels 210 on the base substrate 110 is circular, a shape of the orthographic projection of each of the second color sub-pixels 220 on the base substrate 110 is circular, and a shape of the orthographic projection of each of the third color sub-pixels 230 on the base substrate 110 is circular.

In some examples, as illustrated by Fig. 14, a diameter of the shape of the orthographic projection of each of the third color sub-pixels 230 on the base substrate 110 is larger than a diameter of the shape of the orthographic projection of each of the first color sub-pixels 220 on the base substrate 110; and the diameter of the shape of the orthographic projection of each of the first color sub-pixels 210 on the base substrate 110 is larger than a diameter of the shape of the orthographic projection of each of the second color sub-pixels 220 on the base substrate 110.

In some examples, as illustrated by Fig. 14, the plurality of sub-pixels 200 includes a plurality of sub-pixel groups 260, each of the plurality of sub-pixel groups 260 includes one first color sub-pixel 210, two second color sub-pixels 220 and one third color sub-pixel 230; in each of the plurality of sub-pixel groups 260, the first color sub-pixel 210 and the third color sub-pixel 230 are arranged along the first direction X, the two second color sub-pixels 220 are arranged along the second direction Y, a line connecting a center of the first color sub-pixel 210 and a center of the third color sub-pixel 230 is intersected with a line connecting centers of the two second color sub-pixels 220. Lines connecting centers of the two first color sub-pixels 210 and centers of the two third color sub-pixels 230 in the two adjacent sub-pixel groups 260 in the second direction Y can form a second virtual quadrilateral, and the second virtual quadrilateral is an isosceles trapezoid.

Fig. 15 is a planar schematic diagram of another display substrate provided by an embodiment of the present disclosure. As illustrated by Fig. 15, the display substrate 100 includes a base substrate 110 and a plurality of sub-pixels 200; the plurality of sub-pixels 200 are located on the base substrate 110 and adopt a certain pixel arrangement to perform light emitting display. The plurality of sub-pixels 200 include first color sub-pixels 210, second color sub-pixels 220 and third color sub-pixels 230. A plurality of first color sub-pixels 210 and a plurality of third color sub-pixels 230 may be alternately arranged along the second direction Y, and form first sub-pixel columns 391; a plurality of second color sub-pixels 220 may be arranged along the second direction Y and form second sub-pixel columns 392; and a plurality of first sub-pixel columns 391 and a plurality of second sub-pixel columns 392 are alternately arranged along the first direction. In each of the plurality of first sub-pixel columns 391, a center of an orthographic projection of each of the third color sub-pixels 230 on the base substrate 110 is located on a second virtual straight line 382 extending along the second direction Y, and a center of an orthographic projection of each of the first color sub-pixels 210 on the base substrate 110 is located on one side of a first virtual straight line 381 in the first direction X.

In some examples, as illustrated by Fig. 15, in two adjacent first sub-pixel columns 391 in the first direction X, a center of an orthographic projection of each of the first color sub-pixels 210 in a first sub-pixel column 391 on the base substrate 110 is located on a third side of a second virtual straight line 381 of the row in the first direction X, and a center of an orthographic projection of each of the first color sub-pixels 210 in another first sub-pixel column 391 on the base substrate 110 is located on a fourth side of a second virtual straight line 382 of the column in the first direction X.

In some examples, as illustrated by Fig. 15, a shape of the orthographic projection of each of the first color sub-pixels 210 on the base substrate 110 is circular, a shape of the orthographic projection of each of the second color sub-pixels 220 on the base substrate 110 is circular, and a shape of the orthographic projection of each of the third color sub-pixels 230 on the base substrate 110 is circular.

In some examples, as illustrated by Fig. 15, a diameter of the shape of the orthographic projection of each of the third color sub-pixels 230 on the base substrate 110 is larger than a diameter of the shape of the orthographic projection of each of the first color sub-pixels 220 on the base substrate 110; and the diameter of the orthographic projection of the first color sub-pixel 210 on the base substrate 110 is larger than a diameter of the orthographic projection of each of the second color sub-pixels 220 on the base substrate 110.

In some examples, as illustrated by Fig. 15, the plurality of sub-pixels 200 includes a plurality of sub-pixel groups 260, each of the plurality of sub-pixel groups 260 includes one first color sub-pixel 210, two second color sub-pixels 220 and one third color sub-pixel 230; In each of the plurality of sub-pixel groups 260, the first color sub-pixel 210 and the third color sub-pixel 230 are arranged along the first direction X, the two second color sub-pixels 220 are arranged along the second direction Y, a line connecting a center of the first color sub-pixel 210 and a center of the third color sub-pixel 230 is intersected with a line connecting a center of the two second color sub-pixels 220. Lines connecting centers of the two first color sub-pixels 210 and centers of the two third color sub-pixels 230 in the two adjacent sub-pixel groups 260 in the second direction Y can form a second virtual quadrilateral, and the second virtual quadrilateral is an isosceles trapezoid.

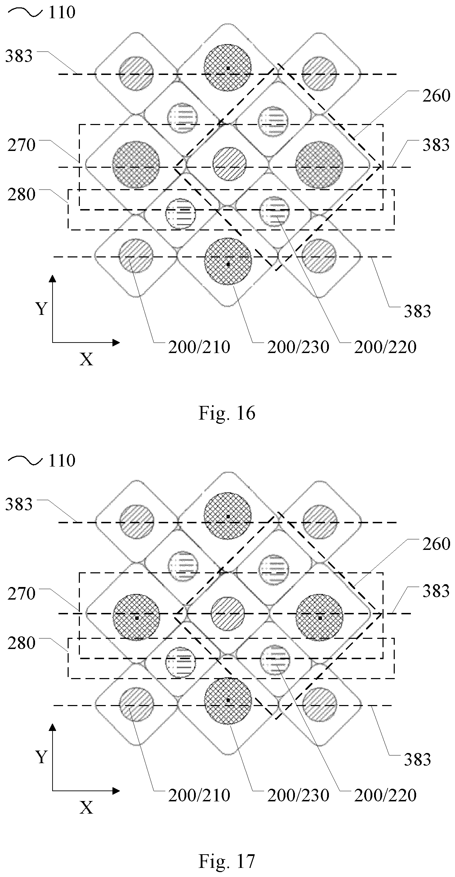

Fig. 16 is a planar schematic diagram of another display substrate provided by an embodiment of the present disclosure. As illustrated by Fig. 16, the display substrate 100 includes a base substrate 110 and a plurality of sub-pixels 200; the plurality of sub-pixels 200 are located on the base substrate 110 and adopt a certain pixel arrangement to perform light emitting display. The plurality of sub-pixels 200 include first color sub-pixels 210, second color sub-pixels 220 and third color sub-pixels 230. A plurality of first color sub-pixels 210 and a plurality of third color sub-pixels 230 may be alternately arranged along the first direction X, and form first sub-pixel rows 270; a plurality of second color sub-pixels 220 may be arranged along the first direction X, and form second sub-pixel rows 280; a plurality of first sub-pixel rows 270 and a plurality of second sub-pixel rows 280 are alternately arranged along the second direction. In each of the plurality of first sub-pixel rows 270, centers of orthographic projections of the plurality of first color sub-pixels 210 on the base substrate 110 are located on a third virtual straight line 381 extending along the first direction X. In at least one first sub-pixel row 270, a center of an orthographic projection of each of the third color sub-pixels 230 on the base substrate 110 is located on one side of the third virtual straight line 383 in the second direction Y.

In some examples, as illustrated by Fig. 16, the center of the orthographic projection of each of the third color sub-pixels 230 on the base substrate 110 is spaced apart from the third virtual straight line 383, that is, a distance between the orthographic projection of each of the third color sub-pixels 230 on the base substrate 110 and the third virtual straight line 383 is greater than 0.

In some examples, as illustrated by Fig. 16, in two adjacent first sub-pixel rows 270 in the second direction Y, a center of an orthographic projection of each of the third color sub-pixels 230 in a first sub-pixel row 270 on the base substrate 110 is spaced apart from the third virtual straight line 383 of the row, and a center of an orthographic projection of each of the third color sub-pixels 230 in another first sub-pixel row 270 on the base substrate 110 is located on the third virtual straight line 383 of the row.

In some examples, as illustrated by Fig. 16, a shape of the orthographic projection of each of the first color sub-pixels 210 on the base substrate 110 is circular, a shape of the orthographic projection of each of the second color sub-pixels 220 on the base substrate 110 is circular, and a shape of the orthographic projection of each of the third color sub-pixels 230 on the base substrate 110 is circular.

In some examples, as illustrated by Fig. 16, a diameter of the orthographic projection of each of the third color sub-pixels 230 on the base substrate 110 is greater than the diameter of the orthographic projection of each of the first color sub-pixels 220 on the base substrate 110; and the diameter of the orthographic projection of the first color sub-pixel 210 on the base substrate 110 is larger than a diameter of the orthographic projection of each of the second color sub-pixels 220 on the base substrate 110 .

In some examples, as illustrated by Fig. 16, in three adjacent first sub-pixel rows 270 in the second direction Y, a center of an orthographic projection of each of the third color sub-pixels 230 in an upper first sub-pixel row 270 on the base substrate 110 is spaced apart from a third virtual straight line 383 of the row, a center of an orthographic projection of each of the third color sub-pixels 230 in a middle first sub-pixel row 270 on the base substrate 110 is located on a third virtual straight line 383 of the row, a center of an orthographic projection of each of the third color sub-pixels 230 in a lower first sub-pixel row 270 on the base substrate 110 is spaced apart from the third virtual straight line 383 of the row, and is opposite to the direction in which the third color sub-pixel 230 in the upper first sub-pixel row 270 is offset relative to the corresponding third virtual straight line 383.

Fig. 17 is a planar schematic diagram of another display substrate provided by an embodiment of the present disclosure. As illustrated by Fig. 17, the display substrate 100 includes a base substrate 110 and a plurality of sub-pixels 200; the plurality of sub-pixels 200 are located on the base substrate 110 and adopt a certain pixel arrangement to perform light emitting display. The plurality of sub-pixels 200 include first color sub-pixels 210, second color sub-pixels 220 and third color sub-pixels 230. A plurality of first color sub-pixels 210 and a plurality of third color sub-pixels 230 may be alternately arranged along the first direction X and form first sub-pixel rows 270; a plurality of second color sub-pixels 220 may be arranged along the first direction X and form second sub-pixel rows 280; a plurality of first sub-pixel rows 270 and a plurality of second sub-pixel rows 280 are alternately arranged along the second direction. In each of the plurality of first sub-pixel rows 270, centers of orthographic projections of the plurality of first color sub-pixels 210 on the base substrate 110 is located on the third virtual straight line 383 extending along the first direction X, and a center of an orthographic projection of each of the third color sub-pixels 230 on the base substrate 110 is located on one side of the third virtual straight line 383 in the second direction Y.

In some examples, as illustrated by Fig. 17, the center of the orthographic projection of each of the third color sub-pixels 230 on the base substrate 110 is spaced apart from the third virtual straight line 383, that is, a distance between the orthographic projection of each of the third color sub-pixels 230 on the base substrate 110 and the third virtual straight line 383 is greater than 0.

In some examples, as illustrated by Fig. 17, in two adjacent first sub-pixel rows 270 in the second direction Y, a center of an orthographic projection of each of the third color sub-pixel 230 in a first sub-pixel row 270 on the base substrate 110 is located on a first side of a third virtual straight line 383 of the row in the second direction Y, and a center of an orthographic projection of each of the third color sub-pixels 230 in another first sub-pixel row 270 on the base substrate 110 is located on a second side of a third virtual straight line 383 of the row in the second direction Y.

In some examples, as illustrated by Fig. 17, a shape of the orthographic projection of each of the first color sub-pixels 210 on the base substrate 110 is circular, a shape of the orthographic projection of each of the second color sub-pixels 220 on the base substrate 110 is circular, and a shape of the orthographic projection of each of the third color sub-pixels 230 on the base substrate 110 is circular.

In some examples, as illustrated by Fig. 17, a diameter of the orthographic projection of each of the third color sub-pixels 230 on the base substrate 110 is greater than a diameter of the orthographic projection of each of the first color sub-pixels 220 on the base substrate 110; and the diameter of the orthographic projection of the first color sub-pixel 210 on the base substrate 110 is larger than a diameter of the orthographic projection of each of the second color sub-pixels 220 on the base substrate 110.

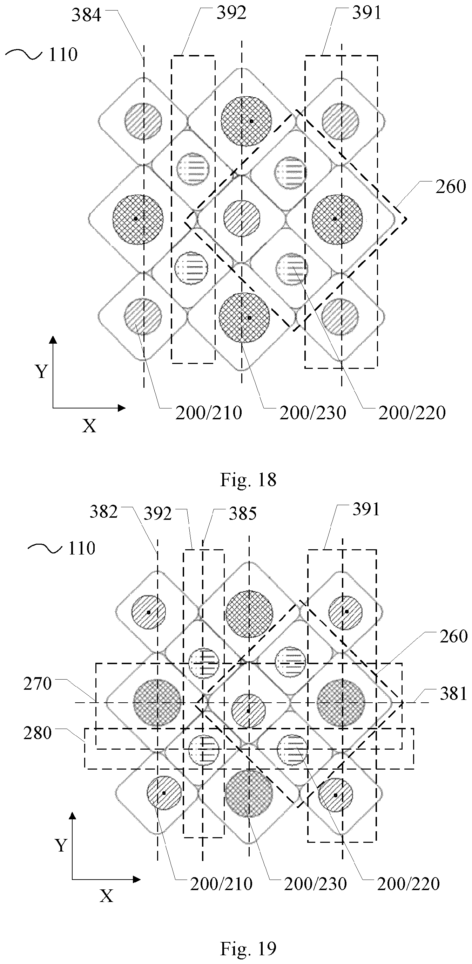

Fig. 18 is a planar schematic diagram of another display substrate provided by an embodiment of the present disclosure. As illustrated by Fig. 18, the display substrate 100 includes a base substrate 110 and a plurality of sub-pixels 200; the plurality of sub-pixels 200 are located on the base substrate 110 and adopt a certain pixel arrangement to perform light emitting display. The plurality of sub-pixels 200 include first color sub-pixels 210, second color sub-pixels 220 and third color sub-pixels 230. A plurality of first color sub-pixels 210 and a plurality of third color sub-pixels 230 may be alternately arranged along the second direction Y and form first sub-pixel columns 391; a plurality of second color sub-pixels 220 may be arranged along the second direction Y and form second sub-pixel columns 392; and a plurality of first sub-pixel columns 391 and a plurality of second sub-pixel columns 392 are alternately arranged along the first direction. In each of the plurality of first sub-pixel columns 391, centers of orthographic projections of the plurality of first color sub-pixels 230 on the base substrate 110 are located on the fourth virtual straight line 384 extending along the second direction Y, and a center of an orthographic projection of each of the third color sub-pixels 210 on the base substrate 110 is located on one side of the fourth virtual straight line 384 in the first direction X.

In some examples, as illustrated by Fig. 18, in two adjacent first sub-pixel columns 391 in the first direction X, a center of an orthographic projection of each of the third color sub-pixels 230 in a first sub-pixel column 391 on the base substrate 110 is located on a third side of a fourth virtual straight line 384 of the row in the first direction X, and a center of an orthographic projection of each of the third color sub-pixels 230 in another first sub-pixel column 391 on the base substrate 110 is located on a fourth side of a fourth virtual straight line 384 of the column in the first direction X.

In some examples, as illustrated by Fig. 18, a shape of the orthographic projection of each of the first color sub-pixels 210 on the base substrate 110 is circular, a shape of the orthographic projection of each of the second color sub-pixels 220 on the base substrate 110 is circular, and a shape of the orthographic projection of each of the third color sub-pixels 230 on the base substrate 110 is circular.

In some examples, as illustrated by Fig. 18, a diameter of the orthographic projection of each of the third color sub-pixels 230 on the base substrate 110 is greater than a diameter of the orthographic projection of each of the first color sub-pixels 220 on the base substrate 110; and the diameter of the orthographic projection of the first color sub-pixel 210 on the base substrate 110 is larger than a diameter of the orthographic projection of each of the second color sub-pixels 220 on the base substrate 110.

Fig. 19 is a planar schematic diagram of another display substrate provided by an embodiment of the present disclosure. As illustrated by Fig. 19, the display substrate 100 includes a base substrate 110 and a plurality of sub-pixels 200; the plurality of sub-pixels 200 are located on the base substrate 110 and adopt a certain pixel arrangement to perform light emitting display. The plurality of sub-pixels 200 include first color sub-pixels 210, second color sub-pixels 220 and third color sub-pixels 230. A plurality of first color sub-pixels 210 and a plurality of third color sub-pixels 230 may be alternately arranged along the second direction Y and form first sub-pixel columns 391; a plurality of second color sub-pixels 220 may be arranged along the second direction Y and form second sub-pixel columns 392; and a plurality of first sub-pixel columns 391 and a plurality of second sub-pixel columns 392 are alternately arranged along the first direction. In each of the plurality of first sub-pixel rows 270, centers of orthographic projections of the plurality of third color sub-pixels 230 on the base substrate 110 are located on a first virtual straight line 381 extending along the first direction X. In at least one first sub-pixel row 270, a center of an orthographic projection of each of the first color sub-pixels 210 on the base substrate 110 is located on one side of the first virtual straight line 381 in the second direction Y; in each of the plurality of first sub-pixel columns 391, centers of orthographic projections of the plurality of third color sub-pixels 230 on the base substrate 110 are located on a second virtual straight line 382 extending along the second direction Y, a center of an orthographic projection of each of the first color sub-pixels 210 on the base substrate 110 is located on one side of the first virtual straight line 381 in the first direction X. That is, the first color sub-pixels 210 may be shifted in the first direction X, or may also be shifted in the second direction Y.

In some examples, as illustrated by Fig. 19, in two adjacent first sub-pixel columns 391 in the first direction X, a center of an orthographic projection of each of the first color sub-pixels 210 in a first sub-pixel column 391 on the base substrate 110 is located on one side of a second virtual straight line 381 of the row in the first direction X, and a center of an orthographic projection of each of the first color sub-pixels 210 in the other first sub-pixel column 391 on the base substrate 110 is located on one side in the second direction Y of a first virtual straight line 381 of the first sub-pixel row 270 where the first color sub-pixel 210 is located.

In some examples, as illustrated by Fig. 19, in each of the second sub-pixel columns 392, centers of orthographic projections of the plurality of second color sub-pixels 220 on the base substrate 110 are located on a fifth virtual straight line 385 extending along the second direction Y; a distance between a fifth virtual straight line 385 of one second sub-pixel column 392 and a second virtual straight line 382 of two adjacent first sub-pixel columns 391 is not equal. That is, in a second sub-pixel row 280, a distance between two adjacent second color sub-pixels 220 has different values, for example, including a first distance value and a second distance value set alternately. It should be noted that in a case that the first color sub-pixels in the display substrate does not shift and the third color sub-pixels shift (for example, the situation shown in FIGS. 16 to 18), each of the second color sub-pixels may also satisfy a similar relationship with the third virtual straight line or the fourth virtual straight line of the first color sub-pixel, and the embodiments of the present disclosure will not be described in detail herein.

In some examples, as illustrated by Fig. 19, a shape of the orthographic projection of each of the first color sub-pixels 210 on the base substrate 110 is circular, a shape of the orthographic projection of each of the second color sub-pixels 220 on the base substrate 110 is circular, and a shape of the orthographic projection of each of the third color sub-pixels 230 on the base substrate 110 is circular.

In some examples, as illustrated by Fig. 19, a diameter of the orthographic projection of each of the third color sub-pixels 230 on the base substrate 110 is greater than a diameter of the orthographic projection of each of the first color sub-pixels 220 on the base substrate 110; and the diameter of the orthographic projection of each of the first color sub-pixels 210 on the base substrate 110 is larger than a diameter of the orthographic projection of each of the second color sub-pixels 220 on the base substrate 110 .

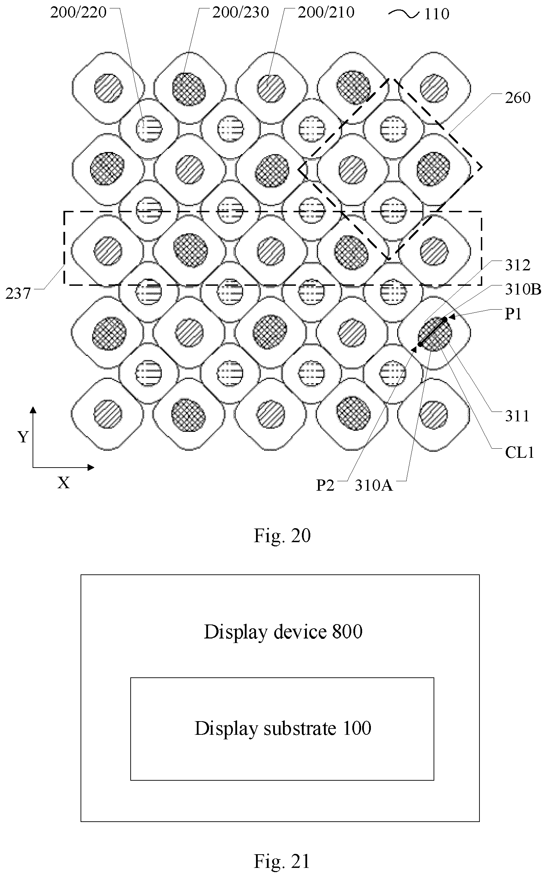

Fig. 20 is a planar schematic diagram of another display substrate provided by an embodiment of the present disclosure. As illustrated by Fig. 20, the display substrate 100 includes a base substrate 110 and a plurality of sub-pixels 200; the plurality of sub-pixels 200 are located on the base substrate 110; a shape of an orthographic projection of at least one sub-pixel 200 on the base substrate 110 includes a first shape 310, the first shape 310 includes a first curved edge 311 and a second curved edge 312; two ends of the first curved edge 311 and the second curved edge 312 are respectively connected to form a first connection point P1 and a second connection point P2. A length of a first connection line CL 1 between the first connection point P1 and the second connection point P2 is a maximum length of the first shape 310 in an extension direction of the first connection line CL1, the first shape 310 is divided by the first connection line CL1 into a first sub-section 310A including a first curved edge 311 and a second sub-section 310B including a second curved edge 312; an area of the first sub-section 310A is greater than an area of the second sub-section 3 10B, and a maximum vertical distance between each point on the first curved edge 311 and the first connection line CL1 is greater than a maximum vertical distance between each point on the second curved edge 312 and the first connection line CL1.

As illustrated by Fig. 20, the plurality of sub-pixels 200 include a plurality of sub-pixel groups 260, each of the plurality of sub-pixel groups 260 includes one first color sub-pixel 210, two second color sub-pixels 220 and one third color sub-pixel 230; in each of the plurality of sub-pixel groups 260, the first color sub-pixel 210 and the third color sub-pixel 230 are arranged along the first direction X, the two second color sub-pixels 220 are arranged along the second direction Y, and a line connecting a center of the first color sub-pixel 210 and a center of the third color sub-pixel 230 is intersected with a line connecting centers of the two second color sub-pixels 220. Of course, as illustrated by Fig. 20, the plurality of sub-pixels 200 are also arranged in an array along the above-mentioned first direction X and second direction Y. In this case, an angle between the first connection line CL1 between the first connection point P1 and the second connection point P2 and the first direction X ranges from 30 to 60 degrees, for example, 45 degrees. In this way, the display substrate has a better display effect. In addition, the display substrate can also avoid color separation to a certain extent. In addition, the display substrate can flexibly adjust the size and distance of different sub-pixels according to the light emitting efficiency and color index of different color sub-pixels by setting the above-mentioned first curved edge and the second curved edge including the first straight edge, to achieve a better display effect. In addition, the display substrate can also form spacers, fingerprint recognition units, photosensitive devices and other functional components at positions where the first straight edge is away from the first curved edge, thus other functions can be better integrated on the display substrate.

In some examples, as illustrated by Fig. 20, the plurality of sub-pixels 200 include first color sub-pixels 210, second color sub-pixels 220, and third color sub-pixels 230; the first color sub-pixels 210 are configured to emit light of a first color, the second color sub-pixels 220 are configured to emit light of a second color, and the third color sub-pixel 230 is configured to emit light of a third color; a shape of an orthographic projection of each of the third color sub-pixels 230 on the base substrate 110 is a first shape 310; a plurality of third color sub-pixels 230 are arranged in an array along the row direction and the column direction to form third color sub-pixel rows 237 extending along the row direction, a plurality of third color sub-pixel rows 237 are arranged sequentially along the column direction; a first curved edge 311 and a second curved edge 312 of the first shape 310 have an arrangement order in a direction perpendicular to the first connection line CL1, in a same third color sub-pixel row 237, two adjacent third color sub-pixels 230 are arranged in opposite order. Therefore, in a same third color sub-pixel row, a distribution of third color sub-pixels with different arrangement orders is relatively uniform, thus it can be ensured that the display effect presented by the display substrate under different viewing angles is the same, to improve the display uniformity under different viewing angles.

In some examples, as illustrated by Fig. 20, an area of each of the third color sub-pixels 230 is larger than an area of each of the first color sub-pixels 210, the area of each of the third color sub-pixel 230 is larger than an area of each of the second color sub-pixels 210. By setting an area of a sub-pixel with a lower light emitting lifetime to be larger, the service life of the sub-pixel with a lower light emitting lifetime can be increased, thereby balancing the service life of different sub-pixels.

For example, the first color may be red, the second color may be green, and the third color may be blue. Of course, the embodiments of the present disclosure include but are not limited thereto, and the first color, the second color and the third color may also be other colors.

In some examples, as illustrated by Fig. 20, a shape of each of the first color sub-pixels 210 may be circular, a shape of each of the second color sub-pixels 220 may also be circular. Of course, the embodiments of the present disclosure include but are not limited thereto, and the shape of each of the first color sub-pixels and the shape of each of the second color sub-pixels can also be other shapes.

In some examples, as illustrated by Fig. 20, the display substrate 100 may be an array substrate for display, a stacking relationship between an anode, a pixel defining layer and a light emitting functional layer in the array substrate in the direction perpendicular to the base substrate can be seen in the relevant descriptions of Fig. 2. Of course, the embodiments of the present disclosure include but are not limited thereto, the display substrate may also be a color filter substrate, please refer to the relevant descriptions of Fig. 3.

At least one embodiment of the present disclosure also provides a display apparatus. Fig. 21 is a schematic diagram of a display apparatus provided by an embodiment of the present disclosure. As illustrated by Fig. 21, the display apparatus 800 includes the display substrate 100 provided by any one of the above examples. In this way, the display apparatus can also reduce or even avoid the occurrence of color separation, and the display apparatus can also flexibly adjust the size and distance of different sub-pixels according to the light emitting efficiency and color indicators of different color sub-pixels, to achieve a better display effect. Moreover, the display substrate can also form spacers, fingerprint recognition units, photosensitive devices and other functional components at positions where the second curved edge is away from the first curved edge, thus other functions can be better integrated on the display substrate.

In some examples, the above-mentioned display apparatus may be a television, a monitor, a navigator, a tablet computer, a notebook computer, a smartphone, or other electronic product with a display function.

The following points need to be explained:
(1) In the drawings of the embodiment of the present disclosure, only the structure related to the embodiment of the present disclosure is involved, and other structures can refer to the general design.
(2) In case of no conflict, features in the same embodiment and different embodiments of the present disclosure can be combined with each other.

The above are only specific embodiments of the present disclosure, but the protection scope of the present disclosure is not limited thereto. Any person familiar with this technical field can easily think of changes or substitutions within the technical scope disclosed in this disclosure, which should be covered by the present disclosure. Therefore, the scope of protection of the present disclosure should be based on the scope of protection of the claims.

## Claims

1. A display substrate, comprising:
a base substrate;
a plurality of sub-pixels, located on the base substrate;
wherein a shape of an orthographic projection of at least one of the plurality of sub-pixels on the base substrate comprises a first shape, the first shape comprises a first curved edge and a second curved edge, two ends of the first curved edge and two ends of the second curved edge are respectively connected to form a first connection point and a second connection point;
a length of a first connection line between the first connection point and the second connection point is a maximum length of the first shape in an extension direction of the first connection line, the first shape is divided by the first connection line into a first sub-section comprising the first curved edge and a second sub-section comprising the second curved edge;
an area of the first sub-section is greater than an area of the second sub-section, a maximum vertical distance between each point on the first curved edge and the first connection line is greater than a maximum vertical distance between each point on the second curved edge and the first connection line.

2. The display substrate according to claim 1, wherein a curvature of a vertex of the first curved edge away from the first connection line is greater than a curvature of a vertex of the second curved edge away from the first connection line.

3. The display substrate according to claim 1, wherein the first curved edge is a continuously curved edge, and the second curved edge is a continuously curved edge.

4. The display substrate according to claim 1, wherein the first curved edge is a continuously curved edge, the second curved edge comprises a first sub-curved edge, a second sub-curved edge and a first straight edge, and the first straight edge is connected with the first sub-curved edge and the second sub-curved edge respectively.

5. The display substrate according to any one of claims 1 to 4, wherein the plurality of sub-pixels comprise first color sub-pixels, second color sub-pixels and third color sub-pixels, a shape of an orthographic projection of each of the third color sub-pixels on the base substrate is the first shape;
a plurality of third color sub-pixels are arranged in an array along a row direction and a column direction to form a third color sub-pixel row extending along the row direction, the plurality of third color sub-pixel rows are arranged sequentially along the column direction;
the first curved edge and the second curved edge of the first shape have an arrangement order in a direction perpendicular to the first connection line, in a same third color sub-pixel row, arrangement orders of two adjacent of the third color sub-pixels are opposite.

6. The display substrate according to claim 5, wherein an extension direction of the first connection line of the first shape of the third color sub-pixel in one of two adjacent third color sub-pixel rows is parallel to the row direction, and an extension direction of the first connection line of the first shape of the third color sub-pixel in the other of the two adjacent third color sub-pixel rows is parallel to the column direction.

7. The display substrate according to claim 5, wherein arrangement orders of the first curved edge and the second curved edge comprise a first order and a second order that are opposite to each other, in a same third color sub-pixel row, a difference between a number of the third color sub-pixels in the first order and a number of the third color sub-pixels in the second order is less than 10.

8. The display substrate according to any one of claims 1 to 7, wherein a shape of an orthographic projection of at least one of the sub-pixels on the base substrate comprises a second shape, the second shape comprises a third curved edge and a fourth curved edge, two ends of the third curved edge and two ends of the fourth curved edge are respectively connected to form a third connection point and a fourth connection point;
a length of the second connection line between the third connection point and the fourth connection point is a maximum length of the second shape in an extension direction of the second connection line, the second shape is divided by the second connection line into a third sub-section comprising the third curved edge and a fourth sub-section comprising the fourth curved edge;
an area of the third sub-section is greater than an area of the fourth sub-section, and a maximum vertical distance between each point on the third curved edge and the second connection line is greater than a maximum vertical distance between each point on the fourth curved edge and the second connection line.

9. The display substrate according to claim 8, wherein a curvature of a vertex of the third curved edge away from the second connection line is greater than a curvature of a vertex of the fourth curved edge away from the second connection line.

10. The display substrate according to claim 8, wherein the third curved edge is a continuously curved edge, and the fourth curved edge is a continuously curved edge.

11. The display substrate according to claim 8, wherein the third curved edge is a continuously curved edge, the fourth curved edge comprises a third sub-curved edge, a fourth sub-curved edge and a second straight edge, and the second straight edge is connected with the third sub-curved edge and the fourth sub-curved edge respectively.

12. The display substrate according to claim 8, wherein a length of the second connection line is smaller than a length of the first connection line.

13. The display substrate according to claim 12, wherein the plurality of sub-pixels comprise first color sub-pixels, second color sub-pixels and third color sub-pixels, a shape of an orthographic projection of the first color sub-pixel on the base substrate is the second shape;
a plurality of the first color sub-pixels are arranged in an array along the row direction and the column direction to form first color sub-pixel rows extending along the row direction, the plurality of first color sub-pixel rows are arranged sequentially along the column direction;
the third curved edge and the fourth curved edge of the second shape have an arrangement order in a direction perpendicular to the second connection line, in a same first color sub-pixel row, arrangement orders of two adjacent first color sub-pixels are opposite.

14. The display substrate according to claim 13, wherein an extension direction of the second connection line of the second shape of the first color sub-pixel in one of two adjacent first color sub-pixel rows is parallel to the row direction, and an extension direction of the second connection line of the second shape of the first color sub-pixel in the other of the two adjacent first color sub-pixel rows is parallel to the column direction.

15. The display substrate according to claim 13, wherein arrangement orders of the third curved edge and the fourth curved edge comprise a third order and a fourth order that are opposite to each other, in a same first color sub-pixel row, a difference between a number of the first color sub-pixels with the third order and a number of the first color sub-pixels with the fourth order is less than 10.

16. The display substrate according to any one of claims 1 to 15, wherein a shape of an orthographic projection of at least one of the sub-pixels on the base substrate comprises a third shape, the third shape comprises a fifth curved edge and a sixth curved edge, two ends of the fifth curved edge and two ends of the sixth curved edge are respectively connected to form a fifth connection point and a sixth connection point;
a length of a third connection line between the fifth connection point and the sixth connection point is a maximum length of the third shape in an extension direction of the third connection line, the third shape is divided by the third connection line into a fifth sub-section comprising the fifth curved edge and a sixth sub-section comprising the sixth curved edge;
an area of the fifth sub-section is equal to an area of the sixth sub-section, and the fifth curved edge and the sixth curved edge are arranged axially symmetrically with respect to the third connection line.

17. The display substrate according to claim 16, wherein the fifth curved edge is a continuously curved edge, and the sixth curved edge is a continuously curved edge.

18. The display substrate according to claim 16, wherein a length of the third connection line is shorter than a length of the first connection line.

19. The display substrate according to claim 16, wherein the plurality of sub-pixels comprise first color sub-pixels, second color sub-pixels and third color sub-pixels, and a shape of an orthographic projection of the second color sub-pixel on the base substrate is the third shape.

20. The display substrate according to any one of claims 1 to 19, wherein the plurality of sub-pixels are arranged in an array on the base substrate to form a display array, the plurality of sub-pixels comprise boundary sub-pixels located at edges of the display array,
a shape of an orthographic projection of at least one of the boundary sub-pixels on the base substrate comprises a fourth shape, the fourth shape comprises a seventh curved edge and an eighth curved edge, two ends of the seventh curved edge and two ends of the eighth curved edge are respectively connected to form a seventh connection point and an eighth connection point;
a length of a fourth connection line between the seventh connection point and the eighth connection point is a maximum length of the fourth shape in an extension direction of the fourth connection line, the fourth shape is divided by the fourth connection line into a seventh sub-section comprising the seventh curved edge and an eighth sub-section comprising the eighth curved edge;
an area of the seventh sub-section is equal to an area of the eighth sub-section, a shape of the seventh curved edge is the same as a shape of the second curved edge, and a shape of the eighth curved edge is the same as the shape of the second curved edge.

21. The display substrate according to claim 20, wherein the seventh curved edge is a continuously curved edge, and the eighth curved edge is a continuously curved edge.

22. The display substrate according to claim 20, wherein a length of the fourth connection line is equal to a length of the first connection line.

23. The display substrate according to any one of claims 1 to 22, further comprising:
a plurality of anodes, located on the base substrate;
a pixel defining layer, located on the base substrate; and
a light emitting functional layer, located at a side of the plurality of anodes and the pixel defining layer away from the base substrate,
wherein the pixel defining layer is arranged with a plurality of pixel openings, the light emitting functional layer comprises a light emitting layer, and the light emitting layer comprises a plurality of light emitting parts, the plurality of light emitting parts are arranged in the plurality of pixel openings and driven by the anodes exposed by the pixel openings, to form a plurality of light emitting structures of the plurality of sub-pixels,
a shape of an orthographic projection of each of the sub-pixels on the base substrate is a shape of an orthographic projection of the pixel opening corresponding to the sub-pixel on the base substrate.

24. The display substrate according to claim 23, wherein in a sub-pixel having the first shape, a shape of an orthographic projection of the light emitting part on the base substrate is a rounded rectangle, the rounded rectangle comprises a first rounded corner part and a second rounded corner part that are oppositely arranged, and the first rounded corner part is located at a side of the first curved edge away from the second curved edge, the second rounded corner part is located at a side of the second curved edge away from the first curved edge,
a distance between a first vertex of the first rounded corner part away from the pixel opening and the first curved edge is less than a distance between a second vertex of the second rounded corner part away from the pixel opening and the second curved edge.

25. The display substrate according to claim 24, wherein in the sub-pixel having the first shape, the rounded rectangle further comprises a third rounded corner part and a fourth rounded corner part arranged oppositely, a line connecting a third vertex of the third rounded corner part away from the pixel opening and a fourth vertex of the fourth rounded corner part far away from the pixel opening is substantially parallel to the first connection line.

26. The display substrate according to any one of claims 1 to 25, further comprising:
a color filter layer, comprising a plurality of color filters,
wherein shapes of the plurality of color filters define a plurality of light emitting regions of the plurality of sub-pixels, and a shape of an orthographic projection of each of the sub-pixels on the base substrate is a shape of an orthographic projection of one of the color filters corresponding to the sub-pixel on the base substrate.

27. The display substrate according to any one of claims 1 to 26, wherein the plurality of sub-pixels comprise a plurality of sub-pixel groups, each of the sub-pixel groups comprises one first color sub-pixel, two second color sub-pixels and one third color sub-pixel;
in each of the sub-pixel groups, the first color sub-pixel and the third color sub-pixel are arranged along a first direction, the two second color sub-pixels are arranged along the second direction, a line connecting centers of the first color sub-pixel and the third color sub-pixel intersects a line connecting centers of the two second color sub-pixels.

28. The display substrate according to claim 27, wherein in each of the sub-pixel groups, a first center connection line and a second center connection line between the center of the first color sub-pixel and the centers of the two second color sub-pixels and a third center connection line and a fourth center connection line between the center of the third color sub-pixel and the centers of the two second color sub-pixels form a virtual quadrilateral, and at least one interior angle of the virtual quadrilateral is not equal to 90 degrees.

29. The display substrate according to claim 28, wherein a value range of an interior angle of the virtual quadrilateral is from 84 degrees to 94 degrees.

30. The display substrate according to claim 27, wherein the center lines connecting the two first color sub-pixels and the two third color sub-pixels in the two adjacent sub-pixel groups in the second direction may form a second virtual quadrilateral, and at least one interior angle of the second virtual quadrilateral is not equal to 90 degrees.

31. The display substrate according to claim 27, wherein in each of the sub-pixel groups, the first color sub-pixel and the two second color sub-pixels have a first distance and a second distance respectively, the third color sub-pixel and the two second color sub-pixels have a third distance and a fourth distance respectively;
at least two of the first distance, the second distance, the third distance and the fourth distance are equal in size.

32. The display substrate according to claim 31, wherein the first distance, the second distance, the third distance and the fourth distance are equal.

33. A display apparatus, comprising the display substrate according to any one of claims 1 to 32.
